# EUROPEAN PATENT APPLICATION

(11) **EP 4 723 116 A1**
(43) Date of publication of application: **08.04.2026**
(21) Application number: 25204460.7
(22) Date of filing: 24.09.2025
(51) Int. Cl.: G11C 7/10, G11C 7/22, G11C 16/26, G11C 16/32

(54) **NONVOLATILE MEMORY DEVICE AND MEMORY SYSTEM INCLUDING THE SAME**

(30) Priority: 07.10.2024 KR 20240135379
(71) Applicant: Samsung Electronics Co., Ltd., Suwon-si, Gyeonggi-do 16677 (KR)
(72) Inventor: KIM, Sangyun, 16677 Suwon-si (KR); KANG, Hyunsuk, 16677 Suwon-si (KR); KANG, Kyoungtae, 16677 Suwon-si (KR); KANG, Dongku, 16677 Suwon-si (KR); CHOI, Youngdon, 16677 Suwon-si (KR)
(74) Representative: Marks & Clerk LLP

(57) **Abstract**

A first group of FIFO registers are connected to page buffer circuits, respectively. The second group of FIFO registers are connected to the first group of FIFO registers. The multiplexer selects one of a plurality of sub data output from the second group of FIFO registers. The control circuit, in response to a first read command, performs a first read operation by sensing a first data stored in a first memory plane and by storing the first sensed data in a corresponding first set of FIFO registers as a first sub data and, in response to a second read command, performs a second read operation by sensing a second data stored in a second memory plane as a second sub data while performing a first output operation to output the first sub data through a multiplexer and a data input/output circuit in response to a first data output command.

## Description

### BACKGROUND

Semiconductor memory devices for storing data may be classified into volatile memory devices and nonvolatile memory devices. Volatile memory devices, such as dynamic random access memory (DRAM) devices which are typically configured to store data by charging or discharging capacitors in memory cells, lose the stored data when power is off.

Nonvolatile memory devices, such as flash memory devices, are widely used for storing an large amount of data. In the nonvolatile memory devices, data input/output (I/O) speed increases for processing the large amount of data and I/O efficiency may be reduced because of direct memory access (DMA) overhead.

### SUMMARY

Some example implementations may provide a nonvolatile memory device capable of performing multi-plane read operation with reduced DMA overhead.

Some example implementations may provide a memory system that includes a nonvolatile memory device capable of performing multi-plane read operation with reduced DMA overhead.

According to some example implementations, a nonvolatile memory device includes a plurality of page buffer circuits corresponding to a plurality of memory planes, a first group of first-in/first-out (FIFO) registers, a second group of FIFO registers, a multiplexer and a control circuit. Each of the plurality of page buffer circuits is connected to a respective one of the plurality of memory planes through corresponding bit-lines. The first group of FIFO registers are connected to the plurality of page buffer circuits, respectively. The second group of FIFO registers are connected to the first group of FIFO registers, respectively. The multiplexer selects one of a plurality of sub data output from the second group of FIFO registers, in response to a plane selection signal. The control circuit controls the plurality of page buffer circuits, the first group of FIFO registers and the second group of FIFO registers. The control circuit, in response to a first read command, performs a first read operation wherein the first read operation comprises sensing a first data stored in a first memory plane among the plurality of memory planes through a first page buffer circuit and storing the first sensed data in a corresponding first set of FIFO registers among the first group of FIFO registers and the second group of FIFO registers as a first sub data and, in response to a second read command, performs a second read operation, wherein the second read operation comprises sensing a second data stored in a second memory plane among the plurality of memory planes through a second page buffer circuit and storing the second sensed data in a corresponding second set of FIFO registers among the first group of FIFO registers and the second group of FIFO registers as a second sub data while performing a first output operation to output the first sub data to a circuit outside of the nonvolatile memory device through the multiplexer and a data input/output circuit in response to a first data output command.

According to some example implementations, a memory system include a nonvolatile memory device to output a read data and a memory controller to control the nonvolatile memory device and correct errors in the read data. The nonvolatile memory device a plurality of page buffer circuits corresponding to a plurality of memory planes, a first group of first-in/first-out (FIFO) registers, a second group of FIFO registers, a multiplexer and a control circuit. Each of the plurality of page buffer circuits is connected to a respective one of the plurality of memory planes through corresponding bit-lines. The first group of FIFO registers are connected to the plurality of page buffer circuits, respectively. The second group of FIFO registers are connected to the first group of FIFO registers, respectively. The multiplexer selects one of plurality of sub data output from the second group of FIFO registers, in response to a plane selection signal. The control circuit controls the plurality of page buffer circuits, the first group of FIFO registers and the second group of FIFO registers. The control circuit, in response to a first read command, performs a first read operation wherein the first read operation comprises sensing a first data stored in a first memory plane among the plurality of memory planes through a first page buffer circuit and storing the first sensed data in a corresponding first set of FIFO registers among the first group of FIFO registers and the second group of FIFO registers as a first sub data and, in response to a second read command, performs a second read operation wherein the second read operation comprises sensing a second data stored in a second memory plane among the plurality of memory planes through a second page buffer circuit and storing the second sensed data in a corresponding second set of FIFO registers among the first group of FIFO registers and the second group of FIFO registers as a second sub data while performing a first output operation to output the first sub data to the memory controller through the multiplexer and a data input/output circuit in response to a first data output command.

According to some example implementations, a nonvolatile memory device includes a memory cell array including a plurality of memory planes, a plurality of page buffer circuits, first group of first-in/first-out (FIFO) registers, a second group of FIFO registers, a multiplexer and a control circuit. The plurality of page buffer circuits correspond to a plurality of memory planes, and each of the plurality of page buffer circuits is connected to a respective one of the plurality of memory planes through corresponding bit-lines. The first group of FIFO register are connected to the plurality of page buffer circuits, respectively. The second group of FIFO registers are connected to the first group of FIFO registers, respectively. The multiplexer selects one of plurality of sub data output from the second group of FIFO registers, in response to a plane selection signal. The control circuit controls the plurality of page buffer circuits, the first group of FIFO registers and the second group of FIFO registers. The control circuit, in response to a first read command, performs a first read operation wherein the first read operation comprises sensing a first data stored in a first memory plane among the plurality of memory planes through a first page buffer circuit and storing the first sensed data in a first FIFO register among the first group of FIFO registers and in a second FIFO register among the second group of FIFO registers as a first sub data and, in response to a second read command, performs a second read operation wherein the second read operation comprises sensing a second data stored in a second memory plane among the plurality of memory planes through a second page buffer circuit and storing the second sensed data in a third FIFO register among the first group of FIFO registers and in a fourth FIFO register among the second group of FIFO registers as a second sub data while performing a first output operation to output the first sub data to a circuit outside of the nonvolatile memory device through the multiplexer and a data input/output circuit in response to a first data output command. The control circuit performs the first output operation immediately with the first data output command.

Accordingly, the nonvolatile memory device may move sensed data from a corresponding memory plane to a corresponding FIFO register among the second group of FIFO registers instead of moving the sensed data to a corresponding page buffer circuit, in response to a read command, and may output the data stored in the corresponding FIFO register as a sub data to a circuit outside through the multiplexer and the data I/O circuit in response to a data output command. Therefore, the nonvolatile memory device may perform the output operation immediately with the data output command. Accordingly, the nonvolatile memory devices may perform multi-plane read operation with reduced DMA overhead.

At least some of the above and other features of the invention are set out in the claims.

### BRIEF DESCRIPTION OF THE DRAWINGS

Illustrative, non-limiting example implementations will be more clearly understood from the following detailed description in conjunction with the accompanying drawings.
FIG. 1 is a block diagram illustrating a memory system according to example implementations.
FIG. 2 is a block diagram illustrating an example of the memory controller in the memory system of FIG. 1 according to example implementations.
FIG. 3 is a block diagram illustrating an example of the nonvolatile memory device in the memory system of FIG. 1 according to example implementations.
FIG. 4 illustrates a portion of the nonvolatile memory device of FIG. 3 according to example implementations.
FIG. 5 is a circuit diagram illustrating a memory plane configuration in the nonvolatile memory device of FIG. 3 according to example implementations.
FIG. 6 schematically illustrates a structure of the nonvolatile memory device of FIG. 3 according to example implementations.
FIG. 7 is a block diagram illustrating an example of the memory plane in FIG. 3 according to example implementations.
FIG. 8 is a circuit diagram illustrating one of the memory blocks of FIG. 7.
FIG. 9 illustrates an example of a structure of a cell string CS in the memory block of FIG. 8.
FIG. 10 is a schematic diagram of a connection of the memory plane to the page buffer circuit in FIG. 3, according to example implementations
FIG. 11 illustrates a page buffer in detail according to example implementations.
FIG. 12 illustrates a data I/O circuit and components associated with two memory planes in the nonvolatile memory device of FIG. 3.
FIG. 13 is a timing diagram illustrating an example operation of the nonvolatile memory device of FIG. 12 according to example implementations.
FIG. 14 is a block diagram illustrating an example of the first FIFO register and the second FIFO register in FIG. 12 according to example implementations.
FIG. 15 is a timing diagram illustrating an example operation of the nonvolatile memory device of FIG. 3 according to example implementations.
FIG. 16 is a timing diagram illustrating an example operation of the nonvolatile memory device of FIG. 3 according to example implementations.
FIG. 17 is a timing diagram illustrating an example operation of the nonvolatile memory device of FIG. 3 according to example implementations.
FIG. 18 is a block diagram illustrating an example of the control circuit in the nonvolatile memory device of FIG. 3 according to example implementations.
FIG. 19 is a block diagram illustrating an example of the voltage generator in the nonvolatile memory device of FIG. 3 according to example implementations.
FIG. 20 is a block diagram illustrating an example of the address decoder in the nonvolatile memory device of FIG. 3 according to example implementations.
FIG. 21 is a flowchart illustrating an example operation of the nonvolatile memory device.
FIG. 22 is a ladder diagram illustrating an example operation of the nonvolatile memory device, according to example implementations.
FIG. 23 is a block diagram illustrating a storage device according to example implementations.
FIG. 24 is a block diagram illustrating an electronic system including a semiconductor device according to some example implementations.

### DETAILED DESCRIPTION

Various example implementations will be described more fully hereinafter with reference to the accompanying drawings, in which some example implementations are shown.

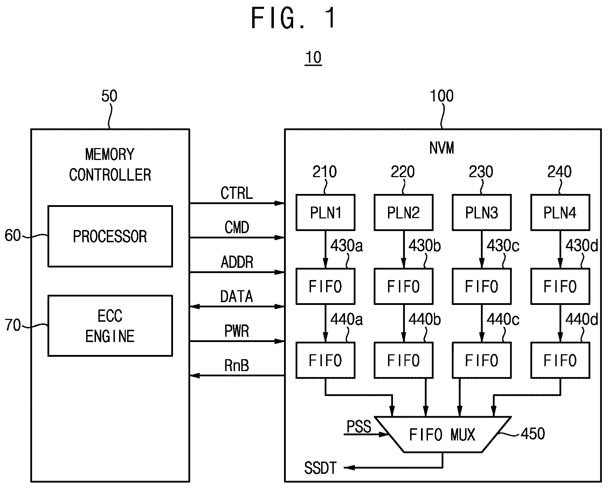

FIG. 1 is a block diagram illustrating a memory system according to example implementations.

Referring to FIG. 1, a memory system 10 may include a memory controller 50 and at least one nonvolatile memory device 100. The memory system 10 may be referred to as a storage device. The at least one nonvolatile memory device 100 may be referred to as a nonvolatile memory device.

In example implementations, each of the memory controller 50 and the nonvolatile memory device 100 may be provided in the form of a chip, a package, or a module. Alternatively, the memory controller 50 and the nonvolatile memory device 100 may be packaged into one of various packages.

The nonvolatile memory device 100 may perform an erase operation, a program operation or a write operation and a read operation under control of the memory controller 50. The nonvolatile memory device 100 may receive a command CMD, an address ADDR and data DATA through input/output lines from the memory controller 50 for performing such operations. In addition, the nonvolatile memory device 100 may receive a control signal CTRL through a control line from the memory controller 50. In addition, the nonvolatile memory device 100 may receive a power PWR through a power line from the memory controller 50. In addition, the nonvolatile memory device 100 may provide the memory controller 50 with a status signal RnB (e.g., a ready/busy signal) indicating an operating status of the nonvolatile memory device 100.

The nonvolatile memory device 100 may include a plurality of memory planes PLN1 (210), PLN2 (220), PLN3 (230) and PLN4 (240) corresponding to different bit-lines, a first group of first-in/first-out (FIFO) registers 430a, 430b, 430c and 430d corresponding to the plurality of memory planes 210, 220, 230 and 240, a second group of FIFO registers 440a, 440b, 440c and 440d corresponding to the first group of FIFO registers 430a, 430b, 430c and 430d and a multiplexer FIFO MUX 450.

Each of the first group of FIFO registers 430a, 430b, 430c and 430d and each of the second group of FIFO registers 440a, 440b, 440c and 440d may sequentially store sensed data from each of the plurality of memory planes 210, 220, 230 and 240 based on a FIFO scheme, in response to a read command.

Each of the second group of FIFO registers 440a, 440b, 440c and 440d may be connected to a respective one of the first group of FIFO registers 430a, 430b, 430c and 430d and the multiplexer 450 may select data which are stored in and output from the second group of FIFO registers 440a, 440b, 440c and 440d in an interleaved manner based on a plane selection signal PSS and in response to a data output command and may provide the selected data to a data input/output circuit as a selected sub data SSDT. The multiplexer 450 may be referred to as a FIFO multiplexer.

The memory controller 50 may include a processor 60 and an error correction code (ECC) engine 70. The ECC engine 70 may be implemented (e.g., configured) to perform an error correction operation on read data from the nonvolatile memory device 100. The error correction operation may apply either a hard decision method or a soft decision method. Here, the hard decision method may be a technique of correcting errors in data using read data and an error correction code according to turning on/off characteristics of the memory cell when a reference voltage is applied (e.g., hard decision data). In addition, the soft decision method may be a technique of correcting data errors by additionally using additional information about reliability of the hard decision data (e.g., soft decision data), separately from the hard decision data and ECC.

For example, the ECC engine 70 may correct hard decision data by changing the log likelihood ratio (LLR) based on soft decision data.

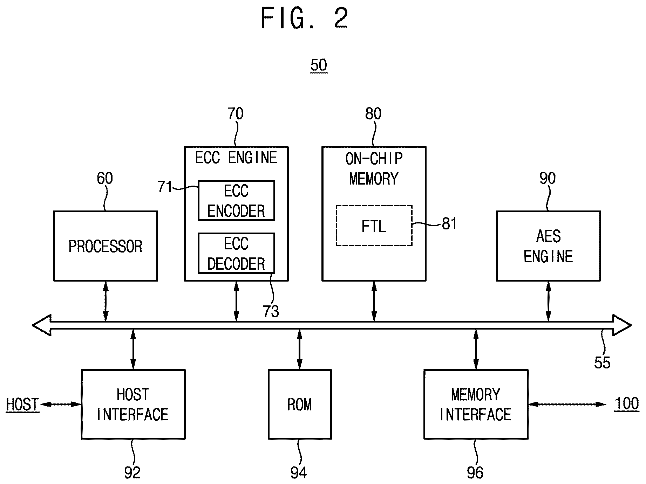

FIG. 2 is a block diagram illustrating an example of the memory controller in the memory system of FIG. 1 according to example implementations.

Referring to FIG. 2, the memory controller 50 may include a processor 60, the ECC engine 70, an on-chip memory 80, an advanced encryption standard (AES) engine 90, a host interface 92, a ROM 94 and a memory interface 96 which are connected via a bus 55.

The processor 60 may control an overall operation of the memory controller 50. The processor 60 may control the ECC engine 70, the on-chip memory 80, the AES engine 90, the host interface 92, the ROM 94 and the memory interface 96. The processor 60 may include one or more cores (e.g., a homogeneous multi-core or a heterogeneous multi-core). The processor 60 may be or include, for example, at least one of a central processing unit (CPU), an image signal processing unit (ISP), a digital signal processing unit (DSP), a graphics processing unit (GPU), a vision processing unit (VPU), and a neural processing unit (NPU). The processor 60 may execute various application programs (e.g., a flash translation layer (FTL) 81 and firmware) loaded onto the on-chip memory 80.

The on-chip memory 80 may store various application programs that are executable by the processor 60. The on-chip memory 80 may operate as a cache memory adjacent to the processor 60. The on-chip memory 80 may store a command, an address, and data to be processed by the processor 60 or may store a processing result of the processor 60. The on-chip memory 80 may be, for example, a storage medium or a working memory including one or more of a latch, a register, a random access memory (RAM), a static random access memory (SRAM), a dynamic random access memory (DRAM), a thyristor random access memory (TRAM), a tightly coupled memory (TCM), etc.

The processor 60 may execute the FTL 81 loaded onto the on-chip memory 80. The FTL 81 may be loaded onto the on-chip memory 80 as firmware or a program stored in the nonvolatile memory device 100. The FTL 81 may manage mapping between a logical address provided from a host and a physical address of the nonvolatile memory device 100 and may include an address mapping table manager for managing and updating an address mapping table. The FTL 81 may further perform a garbage collection operation, a wear leveling operation, and the like, as well as the address mapping described above. The FTL 81 may be executed by the processor 60 for addressing one or more of the following aspects of the nonvolatile memory device 100: overwrite- or in-place write-impossible, a life time of a memory cell, a limited number of program-erase (PE) cycles, and an erase speed slower than a write speed.

Memory cells of the nonvolatile memory device 100 may have the physical characteristic that a threshold voltage distribution varies due to causes, such as a program elapsed time, a temperature, program disturbance, read disturbance, etc. For example, data stored at the nonvolatile memory device 100 may become erroneous due to the above causes.

The memory controller 50 may utilize a variety of error correction techniques to correct such errors. For example, the memory controller 50 may include the ECC engine 70. The ECC engine 70 may correct errors which occur in the data stored in the nonvolatile memory device 100. The ECC engine 70 may include an ECC encoder 71 and an ECC decoder 73. The ECC encoder 71 may perform an ECC encoding operation on data to be stored in the nonvolatile memory device 100. The ECC decoder 73 may perform an ECC decoding operation on data read from the nonvolatile memory device 100. The ECC decoder 73 may correct errors in the hard decision data based on the hard decision data and the soft decision data read from the nonvolatile memory device 100.

The ROM 94 may store a variety of information, needed for the memory controller 50 to operate, in firmware.

The AES engine 90 may perform at least one of an encryption operation and a decryption operation on data input to the memory controller 50 by using a symmetric-key algorithm. Although not illustrated in detail, the AES engine 90 may include an encryption module and a decryption module. For example, the encryption module and the decryption module may be implemented as separate modules. For another example, one module capable of performing both encryption and decryption operations may be implemented in the AES engine 90.

The memory controller 50 may communicate with a host through the host interface 92. For example, the host interface 92 may include Universal Serial Bus (USB), Multimedia Card (MMC), embedded-MMC, peripheral component interconnection (PCI), PCI-express, Advanced Technology Attachment (ATA), Serial-ATA, Parallel-ATA, small computer small interface (SCSI), enhanced small disk interface (ESDI), Integrated Drive Electronics (IDE), Mobile Industry Processor Interface (MIPI), Nonvolatile memory express (NVMe), Universal Flash Storage (UFS), and etc. The memory controller 50 may communicate with the nonvolatile memory device 100 through the memory interface 96.

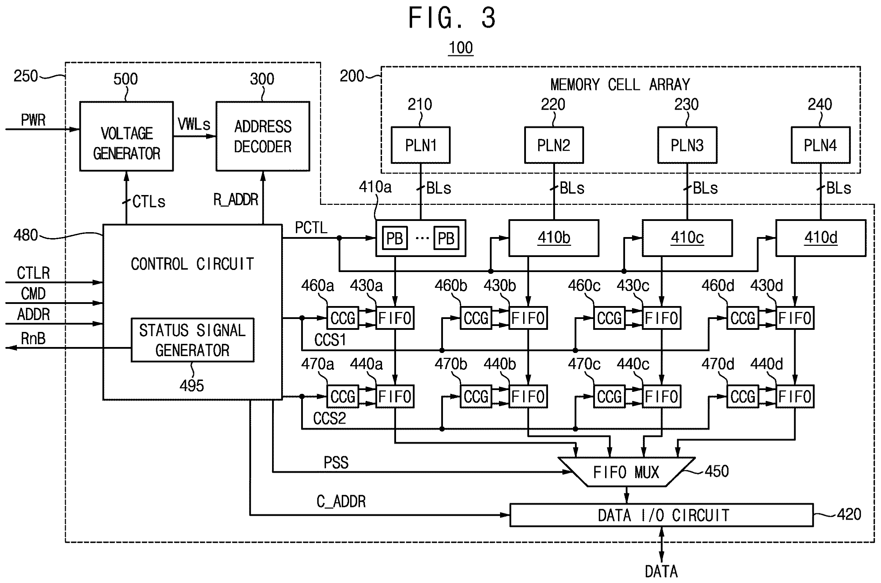

FIG. 3 is a block diagram illustrating an example of the nonvolatile memory device in the memory system of FIG. 1 according to example implementations.

Referring to FIG. 3, the nonvolatile memory device 100 may include a memory cell array 200 and a peripheral circuit 250.

The memory cell array 200 may include the plurality of memory planes 210, 220, 230 and 240.

The peripheral circuit 250 may include a plurality of page buffer circuits 410a, 410b, 410c and 410d, a first group of FIFO registers 430a, 430b, 430c and 430d, a second group of FIFO registers 440a, 440b, 440c and 440d, a plurality of first control clock generators CCGs 460a, 460b, 460c and 460d, a plurality of second control clock generators 470a, 470b, 470c and 470d, a multiplexer 450, a data input/output (I/O) circuit 420, a control circuit 480, a voltage generator 500 and an address decoder 300. The plurality of first control clock generators 460a, 460b, 460c and 460d may be referred to as a first group of control clock generators and the plurality of second control clock generators 470a, 470b, 470c and 470d may be referred to as a second group of control clock generators.

The memory cell array 200 may be coupled to the address decoder 300 through a string selection line SSL, a plurality of word-lines WLs, and a ground selection line GSL. Each of the plurality of page buffer circuits 410a, 410b, 410c and 410d may be connected to a respective one of the plurality of memory planes 210, 220, 230 and 240 through corresponding bit-lines BLs. The plurality of memory planes 210, 220, 230 and 240 may include a plurality of nonvolatile memory cells coupled to the plurality of word-lines WLs and the plurality of bit-lines BLs.

Each of the plurality of memory planes 210, 220, 230 and 240 may include a plurality of memory blocks, and each of the memory blocks may have a three-dimensional (3D) structure. Each of the memory blocks may include a plurality of (vertical) cell strings and each of the cell strings includes a plurality of memory cells stacked with respect to each other. The plurality of memory planes 210, 220, 230 and 240 may comprise a first memory plane 210, a second memory plane 220, a third memory plane 230 and a fourth memory plane 240.

Each of the first group of FIFO registers 430a, 430b, 430c and 430d may be connected to a respective one of the plurality of page buffer circuits 410a, 410b, 410c and 410d and each of the second group of FIFO registers 440a, 440b, 440c and 440d may be connected to a respective one of the first group of FIFO registers 430a, 430b, 430c and 430d. Outputs of the second group of FIFO registers 440a, 440b, 440c and 440d may be connected to the multiplexer 450.

The control circuit 480 may receive the command CMD, the address ADDR, and the control signal CTRL from the memory controller 50 and may control an erase loop, a program loop and a read operation of the nonvolatile memory device 100 based on the command CMD, the address ADDR, and the control signal CTRL. The program loop may include a program operation and a program verification operation and the erase loop may include an erase operation and an erase verification operation.

In example implementations, the control circuit 480 may generate control signals CTLs, which are used for controlling the voltage generator 500, based on the command CMD, may provide the control signals CTLs to the voltage generator 500, may generate a page buffer control signal PCTL for controlling the plurality of page buffer circuits 410a, 410b, 410c and 410d, may provide the page buffer control signal PCTL to the plurality of page buffer circuits 410a, 410b, 410c and 410d, may generate first clock control signals CCS1, may provide the first clock control signals CCS1 to the plurality of first control clock generators 460a, 460b, 460c and 460d, may generate second clock control signals CCS2, may provide the second clock control signals CCS2 to the plurality of second control clock generators 470a, 470b, 470c and 470d, may generate the plane selection signal PSS and may provide the plane selection signal PSS to the multiplexer 450.

Each of the plurality of first control clock generators 460a, 460b, 460c and 460d may provide an input clock signal and an output clock signal to a respective one of the first group of FIFO registers 430a, 430b, 430c and 430d to control operations of the first group of FIFO registers 430a, 430b, 430c and 430d. Each of the plurality of second control clock generators 470a, 470b, 470c and 470d may provide an input clock signal and an output clock signal to a respective one of the second group of FIFO registers 440a, 440b, 440c and 440d to control operations of the second group of FIFO registers 440a, 440b, 440c and 440d.

In addition, the control circuit 480 may generate a row address R_ADDR and a column address C_ADDR based on the address signal ADDR. The control circuit 480 may provide the row address R_ ADDR to the address decoder 300 and may provide the column address C_ADDR to the data I/O circuit 420. The control circuit 480 may include a status generator 495 and the status generator 495 may generate the status signal RnB indicating an operating status of the nonvolatile memory device 100. The status signal RnB may be referred to as a ready/busy signal because the status signal RnB indicates either a busy state or a ready state of the nonvolatile memory device 100.

The address decoder 300 may be coupled to the memory cell array 200 through the string selection line SSL, the plurality of word-lines WLs, and the ground selection line GSL. During program operation or read operation, the address decoder 300 may determine one of the plurality of word-lines WLs as a selected word-line based on the row address R_ADDR and may determine the rest of the plurality of word-lines WLs except the selected word-line as unselected word-lines.

The voltage generator 500 may generate word-line voltages VWLs associated with operations of the nonvolatile memory device 100 using the power PWR provided from the memory controller 50 based on control signals CTLs from the control circuit 450. The word-line voltages VWLs may include a program voltage, a read voltage, a pass voltage, an erase verification voltage, and/or a program verification voltage. The word-line voltages VWLs may be applied to the plurality of word-lines WLs through the address decoder 300.

For example, during the erase operation, the voltage generator 500 may apply erase voltage to a channel of cell strings of a selected memory block and may apply a ground voltage to all word-lines of the selected memory block. During the erase verification operation, the voltage generator 500 may apply erase verification voltage to all word-lines of the selected memory block or may apply the erase verification voltage to the word-lines of the selected memory block by word-line basis.

For example, during the program operation, the voltage generator 500 may apply a program voltage to the selected word-line and may apply a program pass voltage to the unselected word-lines. In addition, during the program verification operation, the voltage generator 500 may apply a program verification voltage to the selected word-line and may apply a verification pass voltage to the unselected word-lines. In addition, during the read operation, the voltage generator 500 may apply a read voltage to the selected word-line and may apply a read pass voltage to the unselected word-lines.

Each of the plurality of page buffer circuits 410a, 410b, 410c and 410d may include a plurality of page buffers PB. Each of the plurality of page buffer circuits 410a, 410b, 410c and 410d may temporarily store data to be programmed in a selected page or data (e.g., the hard decision data and the soft decision data) read out from the selected page of the memory cell array 200.

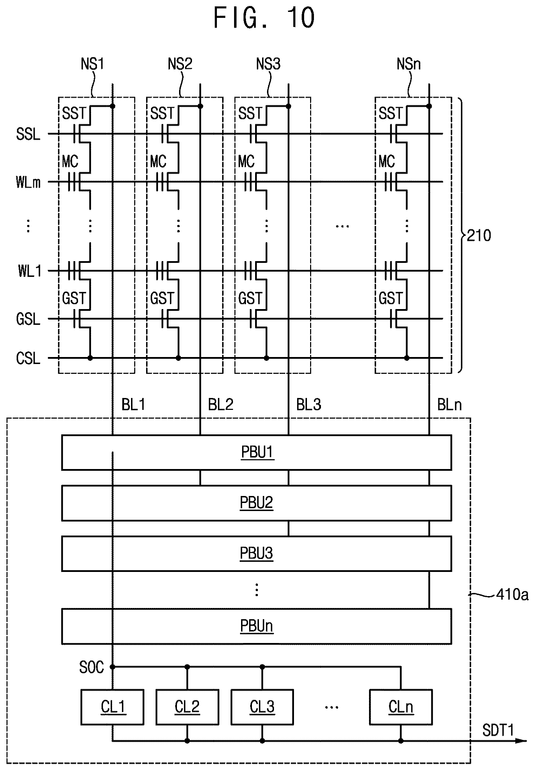

In example implementations, page buffer units included in each of the plurality of page buffers PB (for example, first through n-th page buffer units PBU1 through PBUn in FIG. 10) and cache latches included in each of the plurality of page buffers PB (for example, first through n-th cache latches CL1 through CLn in FIG. 10) may be apart from each other, and have separate structures. Accordingly, the degree of freedom of wirings on the page buffer units may be improved, and the complexity of a layout may be reduced. In addition, because the cache latches are adjacent to data I/O lines, the distance between the cache latches and the data I/O lines may be reduced, and thus, data I/O speed may be improved.

The control circuit 480 may control operation of the nonvolatile memory device 100 based on the control signal CTRL and the command CMD. The control circuit 480, in response to a first read command, may perform a first read operation by sensing first data stored in the first memory plane 210 among the plurality of memory planes 210, 220, 230 and 240 through the first page buffer circuit 410a (to obtain first sensed data (e.g., sensed first data)) and by storing the first sensed data in a corresponding first set of FIFO registers among the first group of FIFO registers 430a, 430b, 430c and 430d and the second group of FIFO registers 440a, 440b, 440c and 440d as first sub data. The control circuit 480, in response to a second read command, may perform a second read operation by sensing second data stored in the second memory plane 220 among the plurality of memory planes 210, 220, 230 and 240 through the second page buffer circuit 410b (to obtain second sensed data (e.g., sensed second data)) and by storing the second sensed data in a corresponding second set of FIFO registers among the first group of FIFO registers 430a, 430b, 430c and 430d and the second group of FIFO registers 440a, 440b, 440c and 440d as second sub data while performing a first output operation to output the first sub data to an outside (e.g., an external circuit) of the nonvolatile memory device 100 through the multiplexer 450 and the data I/O circuit 420 in response to a first data output command.

The control circuit 480, in response a third read command, may perform a third read operation by sensing third data stored the third memory plane 230 among the plurality of memory planes 210, 220, 230 and 240 through the third page buffer circuit 410c (to obtain third sensed data (e.g., sensed third data)) and by storing the third sensed data in a corresponding third set of FIFO registers among the first group of FIFO registers 430a, 430b, 430c and 430d and the second group of FIFO registers 440a, 440b, 440c and 440d as third sub data while performing a second output operation to output the second sub data to a circuit external to the nonvolatile memory device 100 through the multiplexer 450 and the data I/O circuit 420 in response to a second data output command.

The control circuit 480, in response a fourth read command, may perform a fourth read operation by sensing fourth data stored the fourth memory plane 230 among the plurality of memory planes 210, 220, 230 and 240 through the fourth page buffer circuit 410d (to obtain fourth sensed data (e.g., sensed fourth data)) and by storing the fourth sensed data in a corresponding fourth set of FIFO registers among the first group of FIFO registers 430a, 430b, 430c and 430d and the second group of FIFO registers 440a, 440b, 440c and 440d as fourth sub data while performing a third output operation to output the third sub data to a circuit external to the nonvolatile memory device 100 through the multiplexer 450 and the data I/O circuit 420 in response to a third data output command.

The control circuit 480 may perform the first output operation immediately with (e.g., immediately upon receipt of) the first data output command, may perform the second output operation immediately with (e.g., immediately upon receipt of) the second data output command and may perform the third output operation immediately with (e.g., immediately upon receipt of) the third data output command.

In example implementations, the first data, the second data, the third data and the fourth data stored in the plurality of memory planes 210, 220, 230 and 240, respectively, may have the same logical unit number. In example implementations, at least two of the first data, the second data, the third data and the fourth data stored in the plurality of memory planes 210, 220, 230 and 240, respectively, may have different logical unit numbers. The logical unit number may correspond to a minimum unit capable of executing a command independently. For instance, a logical unit number may correspond to a unique identifier for a logical unit of storage (e.g., a logical partition of a storage device). A logical unit identifier may be specify a logical partition of a storage device, presented as a singular storage volume to a host server, which may correspond to a minimum unit capable of executing a command independently.

Therefore, the nonvolatile memory device 100 may move sensed data from a corresponding memory plane to a corresponding FIFO register among the second group of FIFO registers 440a, 440b, 440c and 440d instead of moving the sensed data to a corresponding page buffer circuit, in response to a read command, and may output the data stored in the corresponding FIFO register as a sub data to a circuit external to the nonvolatile memory device 100 through the multiplexer 450 and the data I/O circuit 420 in response to a data output command. That is, the nonvolatile memory device 100 may perform the output operation immediately with the data output command. Therefore, the nonvolatile memory device 100 may perform the output operation without delay time tWHR2 corresponding to a delay between a time point at which the nonvolatile memory device 100 receives the data output command and a time point at which the nonvolatile memory device 100 outputs the data. Accordingly, the nonvolatile memory device 100 may perform a multi-plane read operation with reduced DMA overhead.

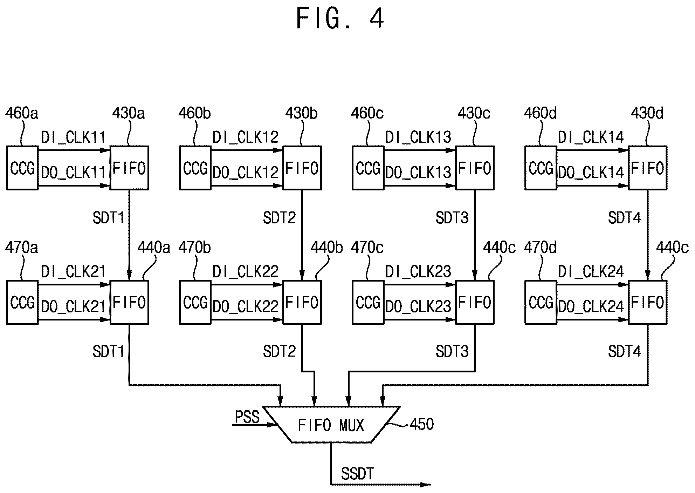

FIG. 4 illustrates a portion of the nonvolatile memory device of FIG. 3 according to example implementations.

Referring to FIGS. 3 and 4, each of the first group of control clock generators 460a, 460b, 460c and 460d may control an input operation and an output operation of each of the first group of FIFO registers 430a, 430b, 430c and 430d by applying a respective one of input clock signals DI_CLK11, DI_CLK12, DI_CLK13 and DI_CLK14 and a respective one of output clock signals DO_CLK11, DO_CLK12, DO_CLK13 and DO_CLK14. Each of the second group of control clock generators 470a, 470b, 470c and 470d may control an input operation and an output operation of each of the second group of FIFO registers 440a, 440b, 440c and 440d by applying a respective one of input clock signals DI_CLK21, DI_CLK22, DI_CLK23 and DI_CLK24 and a respective one of output clock signals DO_CLK21, DO_CLK22, DO_CLK23 and DO_CLK24.

For example, first sub data SDT1 may be provided to the multiplexer 450 through a first set of FIFO registers 430a and 440a, second sub data SDT2 may be provided to the multiplexer 450 through a second set of FIFO registers 430b and 440b, third sub data SDT3 may be provided to the multiplexer 450 through a third set of FIFO registers 430c and 440c, and fourth sub data SDT4 may be provided to the multiplexer 450 through a fourth set of FIFO registers 430d and 440d. The multiplexer 450 may sequentially select the first sub data SDT1, the second sub data SDT2, the third sub data SDT3 and the fourth sub data SDT4, in response to the plane selection signal PSS, and may provide the selected sub data SSDT to the data I/O circuit 420.

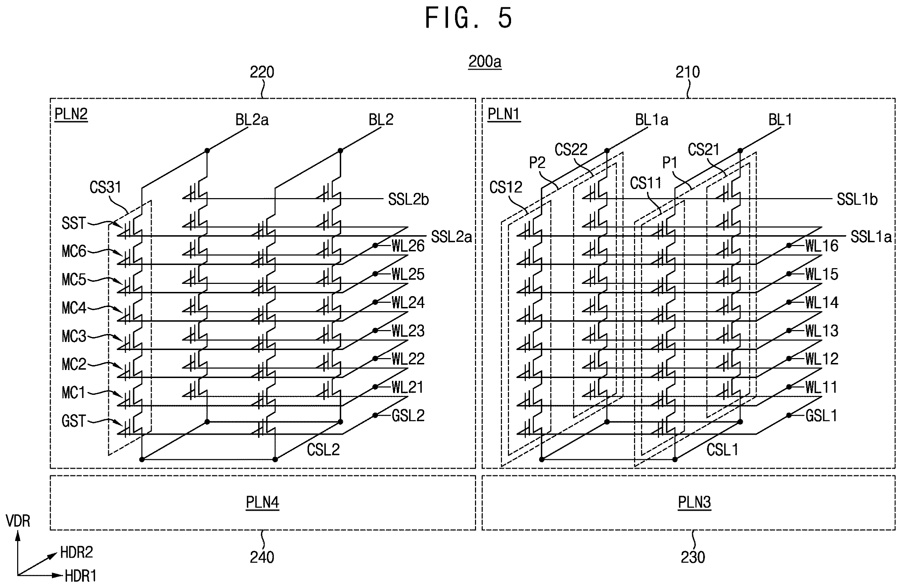

FIG. 5 is a circuit diagram illustrating a memory plane configuration in the nonvolatile memory device of FIG. 3 according to example implementations.

Referring to FIG. 5, a memory cell array 200a including the plurality of memory planes 210, 220, 230 and 240 is illustrated. Each of the plurality of memory planes 210, 220, 230 and 240 may include a plurality of memory blocks which are formed in a first horizontal direction HDR1, a second horizontal direction HDR2 and a vertical direction VDR, and each of the memory blocks may include a plurality of cell strings. For example, a memory block of the memory plane 210 may include a plurality of cell strings CS11, CS12, CS21, and CS22. In FIG. 4, the configuration of each of the memory planes 210 and 220 are illustrated in detail for convenience of explanation, and the configuration of each of the memory planes 230 and 240 may be substantially the same as the configuration of each of the memory planes 210 and 220.

Each of the memory planes (first and second memory planes) 210 and 220 may include a plurality of memory blocks, and one of the memory blocks may have multiple string selection lines SSL1a and SSL1b to select at least one of the cell strings CS11, CS12, CS21, and CS22. For example, when a selection voltage is applied to a first string selection line SSL1a, the first and second cell strings CS11 and CS12 may be selected. When a selection voltage is applied to a second string selection line SSL1b, third and fourth cell strings CS21 and CS22 may be selected.

In some implementations, the memory planes 210 and 220 may have the same physical structure. For example, like the memory plane 210, the memory plane 220 may include multiple memory blocks and multiple cell strings formed in a memory block of the multiple memory blocks. Also, the memory plane 220 may include multiple string selection lines SSL2a and SSL2b to select at least one of multiple cell strings.

Each of the memory planes 210 and 220 may be coupled to corresponding word-lines and a common source line. The cell strings in the memory plane 210 may be coupled to word-lines WL11~WL16, a ground selection line GSL1 and a common source line CSL1. The cell strings in the memory plane 220 may be coupled to word-lines WL21~WL26, a ground selection line GSL2 and a common source line CSL2.

The memory planes 210 and 220 do not share bit- lines. First bit-lines BL1 and BL1a are coupled to the memory plane 210 exclusively. Second bit-lines BL2 and BL2a are coupled to the memory plane 220 exclusively.

Although FIG. 5 illustrates an example in which each memory plane is connected with two bit-lines and six word-lines, example implementations are not limited to these features. For example, each memory plane may be connected with three or more bit-lines and seven or more word-lines. More generally, each memory plane may be connected with a plurality of bit-lines and a plurality of word-lines.

Each cell string may include at least one string selection transistor, memory cells, and at least one ground selection transistor. For example, a cell string CS31 of the memory plane 220 may include a ground selection transistor GST, multiple memory cells MC1 to MC6, and a string selection transistor SST sequentially being perpendicular to a substrate. The remaining cell strings may be formed substantially the same as the cell string CS31.

The memory planes 210 and 220 may include independent string selection lines. For example, string selection lines SSL1a and SSL1b are only connected with the memory plane 210, and string selection lines SSL2a and SSL2b are only connected with the memory plane 220. A string selection line may be used to select cell strings only in a memory plane. Also, cell strings may be independently selected in every memory plane by controlling the string selection lines independently.

For example, cell strings CS11 and CS12 may be independently selected by applying a selection voltage only to first string selection line SSL1a. When the selection voltage is applied to first string selection line SSL1a, string selection transistors of cell strings CS11 and CS12 corresponding to first string selection line SSL1a may be turned on by the selection voltage. At this time, memory cells of the cell strings CS11 and CS12 may be electrically connected with a bit-line. When a non-selection voltage is applied to first string selection line SSL1a, string selection transistors of cell strings CS11 and CS12 corresponding to first string selection line SSL1a are turned off by the non-selection voltage. At this time, memory cells of the cell strings CS11 and CS12 are electrically isolated from a bit-line BL1.

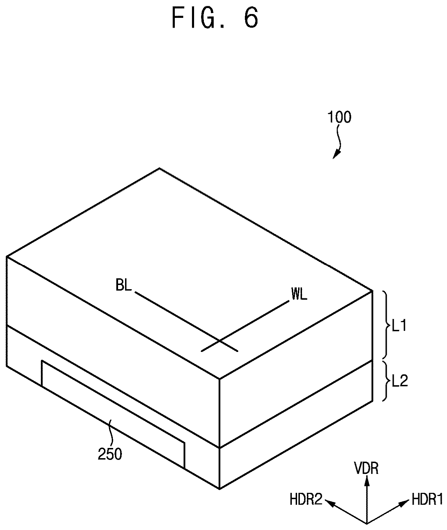

FIG. 6 schematically illustrates a structure of the nonvolatile memory device of FIG. 3 according to example implementations.

Referring to FIG. 6, the nonvolatile memory device 100 may include a first semiconductor layer L1 and a second semiconductor layer L2, and the first semiconductor layer L1 may be stacked in the vertical direction VDR with respect to the second semiconductor layer L2. The second semiconductor layer L2 may be under the first semiconductor layer L1 in the vertical direction VDR, and accordingly, the second semiconductor layer L2 may be closer to a substrate. The vertical direction VDR may be defined as a direction in which the first semiconductor layer L1 and the second semiconductor layer L2 are stacked. The vertical direction VDR may be a direction perpendicular to a first surface of the substrate, upon which the first semiconductor layer L1 and the second semiconductor layer L2 are stacked. While the term "vertical direction" is used, this direction may alternatively be referred to as a "first direction". A direction perpendicular to the vertical direction may be referred to as a "horizontal direction". For instance, the first horizontal direction HDR1 and the second horizontal direction HDR2 may be perpendicular to the vertical direction VDR. The first horizontal direction HDR1 and the second horizontal direction HDR2 may be alternatively referred to as a "second direction" and "a third direction". It will be appreciated that these directions are defined relative to the structure of the nonvolatile memory device 100 and need not imply any particular orientation of the nonvolatile memory device 100 in use.

In example implementations, the memory cell array 200 in FIG. 3 may be formed (or, provided) on (or in) the first semiconductor layer L1, and the peripheral circuit 250 in FIG. 3 may be formed (or, provided) on (or in) the second semiconductor layer L2. Accordingly, the nonvolatile memory device 100 may have a structure in which the memory cell array 200 is on the peripheral circuit 210, that is, a cell over periphery (COP) structure. The COP structure may effectively reduce an area in a horizontal direction and improve the degree of integration of the nonvolatile memory device 100.

In example implementations, the second semiconductor layer L2 may include the substrate, and by forming transistors on the substrate and metal patterns for wiring transistors, the peripheral circuit 250 may be formed in the second semiconductor layer L2. After the peripheral circuit 250 is formed on the second semiconductor layer L2, the first semiconductor layer L1 including the memory cell array 200 may be formed, and the metal patterns for connecting the word-lines WL and the bit-lines BL of the memory cell array 210 to the peripheral circuit 200 formed in the second semiconductor layer L2 may be formed. For example, the word-lines WL may extend in the first horizontal direction HDR1, and the bit-lines BL may extend in the second horizontal direction HDR2.

As the number of stages of memory cells in the memory cell array 200 increases with the development of semiconductor processes, that is, as the number of stacked word-lines WL increases, an area of the memory cell array 200 may decrease, and accordingly, an area of the peripheral circuit 250 may also be reduced. According to some implementations, to reduce an area of a region occupied by the page buffer circuits 410a, 410b, 410c and 410d, each of the page buffer circuits 410a, 410b, 410c and 410d may have a structure in which the page buffer unit and the cache latch are separated from each other, and may connect sensing nodes included in each of the page buffer units commonly to a combined sensing node. This will be explained in detail with reference to FIG. 10.

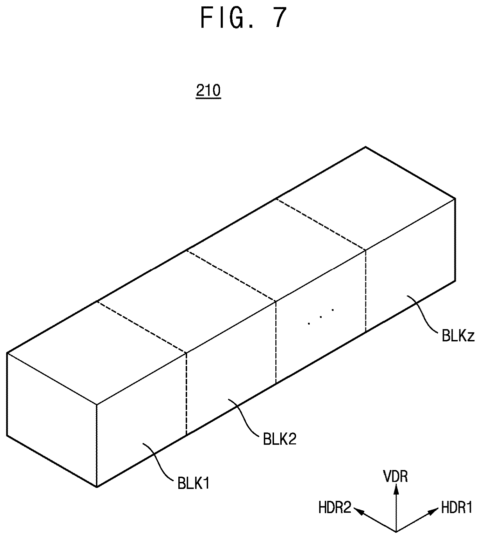

FIG. 7 is a block diagram illustrating an example of the memory plane in FIG. 3 according to example implementations.

Referring to FIG. 7, the memory plane 210 may include a plurality of memory blocks BLK1 to BLKz which extend along a plurality of directions HDR1, HDR2 and VDR. Here, z is an integer greater than two. In some implementations, the memory blocks BLK1 to BLKz are selected by the address decoder 300 in FIG. 3. For example, the address decoder 300 may select a memory block corresponding to a block address among the memory blocks BLK1 to BLKz.

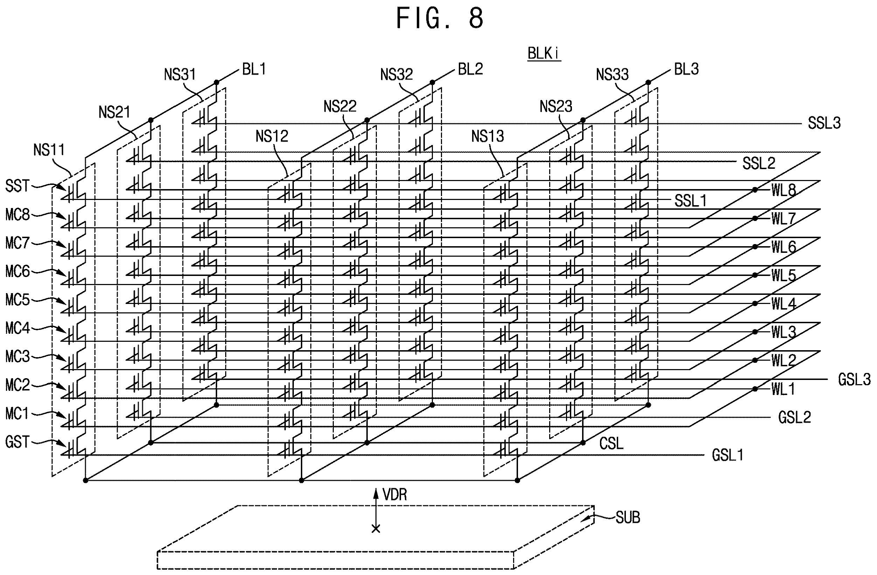

FIG. 8 is a circuit diagram illustrating one of the memory blocks of FIG. 7.

A memory block BLKi of FIG. 8 may be formed on a substrate SUB in a three-dimensional structure (or a vertical structure). For example, a plurality of (memory) cell strings included in the memory block BLKi may be formed in the vertical direction VDR perpendicular to the substrate SUB.

Referring to FIG. 8, the memory block BLKi may include a plurality of cell strings NS11, NS21, NS31, NS12, NS22, NS32, NS13, NS23 and NS33 (hereinafter, represented as NS11 to NS33) coupled between bit-lines BL1, BL2 and BL3 and a common source line CSL. Each of the cell strings NS11 to NS33 may include a string selection transistor SST, a plurality of memory cells MC1, MC2, MC3, MC4, MC5, MC6, MC7 and MC8 (hereinafter represented as MC1 to MC8), and a ground selection transistor GST. In FIG. 7, each of the cell strings NS11 to NS33 is illustrated to include eight memory cells MC1 to MC8. However, the present disclosure is not limited thereto. In some example implementations, each of the cell strings NS11 to NS33 may include any number of memory cells.

The string selection transistor SST may be connected to corresponding string selection lines SSL1, SSL2 and SSL3 (hereinafter, represented as SSL1 to SSL3). The plurality of memory cells MC1 to MC8 may be connected to corresponding word-lines WL1 to WL8, respectively. The ground selection transistor GST may be connected to corresponding ground selection lines GSL1, GSL2 and GSL3 (hereinafter, represented as GSL1 to GSL3). The string selection transistor SST may be connected to corresponding bit-lines BL1, BL2 and BL3, and the ground selection transistor GST may be connected to the common source line CSL.

Word-lines (e.g., WL1) having the same height may be commonly connected, and the ground selection lines GSL1 to GSL3 and the string selection lines SSL1 to SSL3 may be separated.

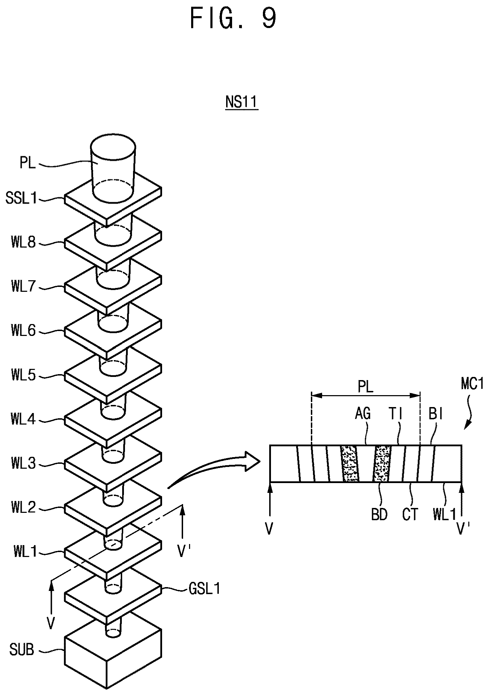

FIG. 9 illustrates an example of a structure of a cell string CS in the memory block of FIG. 8.

Referring to FIGS. 8 and 9, a pillar PL is provided on the substrate SUB such that the pillar PL extends in a direction perpendicular to the substrate SUB to make contact with the substrate SUB. Each of the ground selection line GSL, the word-lines WL1 to WL8, and the string selection lines SSL1 illustrated in FIG. 9 may be formed of a conductive material parallel with the substrate SUB, for example, a metallic material. The pillar PL may be in contact with the substrate SUB through the conductive materials forming the string selection lines SSL, the word-lines WL1 to WL8, and the ground selection line GSL1.

A sectional view taken along a line V-V' is also illustrated in FIG. 9. In some example implementations, a sectional view of a first memory cell MC1 corresponding to a first word-line WL1 is illustrated. The pillar PL may include a cylindrical body BD. An air gap AG may be defined in the interior of the body BD.

The body BD may include P-type silicon and may be an area where a channel will be formed. The pillar PL may further include a cylindrical tunnel insulating layer TI surrounding the body BD and a cylindrical charge trap layer CT surrounding the tunnel insulating layer TI. A blocking insulating layer BI may be provided between the first word-line WL1 and the pillar PL. The body BD, the tunnel insulating layer TI, the charge trap layer CT, the blocking insulating layer BI, and the first word-line WL1 may constitute or be included in a charge trap type transistor that is formed in a direction perpendicular to the substrate SUB or to an upper surface of the substrate SUB. A string selection transistor SST, a ground selection transistor GST, and other memory cells may have the same structure as the first memory cell MC1.

FIG. 10 is a schematic diagram of a connection of the memory plane to the page buffer circuit in FIG. 3, according to example implementations.

Referring to FIG. 10, the memory plane 210 (e.g., a first memory plane) may include first through n-th cell strings NS1, NS2, NS3, ..., NSn (hereinafter, represented as NS1 through NSn), each of the first through n-th cell strings NS1 through NSn may include a ground select transistor GST connected to the ground select line GSL, a plurality of memory cells MC respectively connected to the first through m-th word-lines WL1, ..., WLm (hereinafter, represented as WL1 through WLm), and a string select transistor SST connected to the string select line SSL, and the ground select transistor GST, the plurality of memory cells MC, and the string select transistor SST may be connected to each other in series. In this case, m may be a positive integer.

The page buffer circuit 410a (e.g., a first page buffer circuit) may include first through n-th page buffer units PBU1, PBU2, PBU3, ..., PBUn (hereinafter, represented as PBU1 through PBUn). The first page buffer unit PBU1 may be connected to the first cell string NS1 via the first bit-line BL1, and the n-th page buffer unit PBUn may be connected to the n-th cell string NSn via the n-th bit-line BLn. In this case, the number n is an integer greater than 3. For example, n may be 8, and the page buffer circuit 410 may have a structure in which page buffer units of eight stages, or, the first through n-th page buffer units PBU1 through PBUn are in a line. For example, the first through n-th page buffer units PBU1 through PBUn may be in a row in an extension direction of the first through n-th bit-lines BL1 through BLn.

The page buffer circuit 410a may further include first through n-th cache latches CL1, CL2, CL3, ..., CLn (hereinafter, represented as CL1 through CLn) respectively corresponding to the first through n-th page buffer units PBU1 through PBUn. For example, the page buffer circuit 410 may have a structure in which the cache latches of eight stages or the first through n-th cache latches CL1 through CLn are in a line. For example, the first through n-th cache latches CL1 through CLn may be in a row in an extension direction of the first through n-th bit-lines BL1 through BLn.

The sensing nodes of each of the first through n-th page buffer units PBU1 through PBUn may be commonly connected to a combined sensing node SOC. In addition, the first through n-th cache latches CL1 through CLn may be commonly connected to the combined sensing node SOC. Accordingly, the first through n-th page buffer units PBU1 through PBUn may be connected to the first through n-th cache latches CL1 through CLn via the combined sensing node SOC. The first through n-th cache latches CL1 through CLn may output the first sub data SDT1.

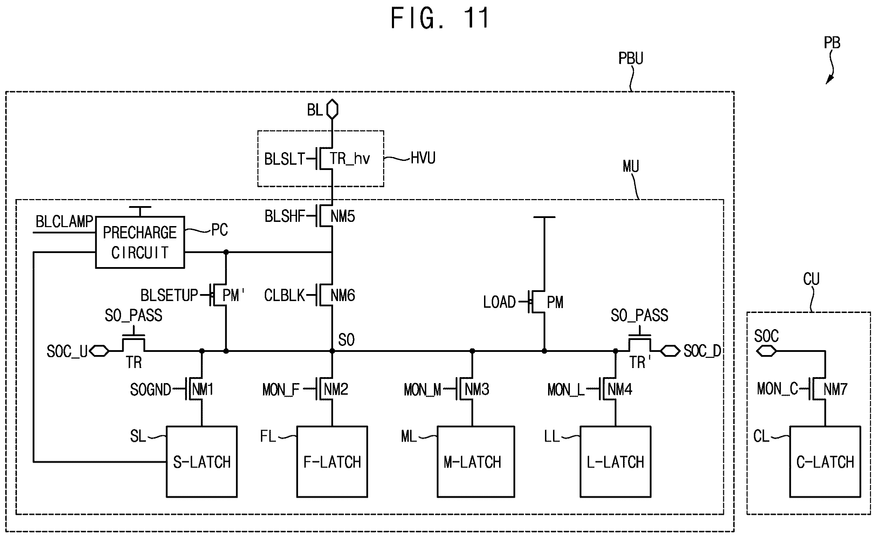

FIG. 11 illustrates a page buffer in detail according to example implementations.

Referring to FIG. 11, the page buffer PB may correspond to an example of the page buffer PB in FIG. 3. The page buffer PB may include a page buffer unit PBU and a cache unit CU. Because the cache unit CU includes a cache latch (C-LATCH) CL, and the C-LATCH CL is connected to a global data line, the cache unit CU may be adjacent to the global data line. Accordingly, the page buffer unit PBU and the cache unit CU may be apart from each other, and the page buffer PB may have a structure in which the page buffer unit PBU and the cache unit CU are apart from each other.

The page buffer unit PBU may include a main unit MU. The main unit MU may include main transistors in the page buffer PB. The page buffer unit PBU may further include a bit-line selection transistor TR_hv that is connected to the bit-line BL and driven by a bit-line selection signal BLSLT. The bit-line selection transistor TR_hv may include a high voltage transistor, and accordingly, the bit-line selection transistor TR_hv may be in a different well region from the main unit MU, that is, in a high voltage unit HVU. For instance, the bit-line selection transistor TR_hv may have a higher breakdown voltage than the main transistors.

The main unit MU may include a sensing latch (S-LATCH) SL, a force latch (F-LATCH) FL, an upper bit latch (M-LATCH) ML and a lower bit latch (L-LATCH) LL. According to some implementations, the S-LATCH SL, the F-LATCH FL, the M-LATCH ML, or the L-LATCH LL may be referred to as main latches or data latches. The main unit MU may further include a precharge circuit PC capable of controlling a precharge operation on the bit-line BL or controlling a sensing node SO based on a bit-line clamping control signal BLCLAMP, and may further include a transistor PM' driven by a bit-line setup signal BLSETUP.

The S-LATCH SL may, during a read or program verification operation, store data stored in a memory cell MC or a sensing result of a threshold voltage of the memory cell MC. In addition, the S-LATCH SL may, during a program operation, be used to apply a program bit-line voltage or a program inhibit voltage to the bit-line BL.

The F-LATCH FL may be used to improve threshold voltage distribution during the program operation. The F-LATCH FL may store force data. After the force data is initially set to '1', the force data may be converted to '0' when the threshold voltage of the memory cell MC enters a forcing region that has a lower voltage than a target region. By utilizing the force data during a program execution operation, the bit-line voltage may be controlled, and the program threshold voltage distribution may be formed more narrowly.

The M-LATCH ML, the L-LATCH LL, and the C-LATCH CL may be utilized to store data externally input during the program operation, and may be referred to as data latches. When data of 3 bits is programmed in one memory cell MC, the data of 3 bits may be stored in the M-LATCH ML, the L-LATCH LL, and the C-LATCH CL, respectively. Until a program of the memory cell MC is completed, the M-LATCH ML, the L-LATCH LL, and the C-LATCH CL may maintain the stored data. In addition, the C-LATCH CL may receive data read from a memory cell MC during the read operation from the S-LATCH SL, and output the received data to the outside circuit via the global data line.

In addition, the main unit MU may further include first through fourth transistors NM1 through NM4. The first transistor NM1 may be connected between the sensing node SO and the S-LATCH SL, and may be driven by a ground control signal SOGND. The second transistor NM2 may be connected between the sensing node SO and the F-LATCH FL, and may be driven by a forcing monitoring signal MON_F. The third transistor NM3 may be connected between the sensing node SO and the M-LATCH ML, and may be driven by a higher bit monitoring signal MON_M. The fourth transistor NM4 may be connected between the sensing node SO and the L-LATCH LL, and may be driven by a lower bit monitoring signal MON_L.

In addition, the main unit MU may further include fifth and sixth transistors NM5 and NM6 connected to each other in series between the bit-line selection transistor TV_hv and the sensing node SO. The fifth transistor NM5 may be driven by a bit-line shut-off signal BLSHF, and the sixth transistor NM6 may be driven by a bit-line connection control signal CLBLK. In addition, the main unit MU may further include a precharge transistor PM. The precharge transistor PM may be connected to the sensing node SO, driven by a load signal LOAD, and precharge the sensing node SO to a precharge level in a precharge period.

In some implementations, the main unit MU may further include a pair of pass transistors connected to the sensing node SO, or first and second pass transistors TR and TR'. According to some implementations, the first and second pass transistors TR and TR' may also be referred to as first and second sensing node connection transistors, respectively. The first and second pass transistors TR and TR' may be driven in response to a pass control signal SO_PASS.

According to some implementations, the pass control signal SO_PASS may be referred to as a sensing node connection control signal. The first pass transistor TR may be connected between a first terminal SOC_U and the sensing node SO, and the second pass transistor TR' may be between the sensing node SO and a second terminal SOC_D.

For example, when the page buffer unit PBU corresponds to the second page buffer unit PBU2 in FIG. 10, the first terminal SOC_U may be connected to one end of the pass transistor included in the first page buffer unit PBU1, and the second terminal SOC_D may be connected to one end of the pass transistor included in the third page buffer unit PBU3. In this manner, the sensing node SO may be electrically connected to the combined sensing node SOC via pass transistors included in each of the third through n-th page buffer units PBU3 through PBUn.

During the program operation, the page buffer PB may verify whether the program is completed in a memory cell selected among the memory cells included in the cell string connected to the bit-line BL. The page buffer PB may store data sensed via the bit-line BL during the program verify operation in the S-LATCH SL. The M-LATCH ML and the L-LATCH LL may be set so that target data is stored according to the sensed data stored in the S-LATCH SL.

For example, when the sensed data indicates that the program is completed, the M-LATCH ML and the L-LATCH LL may be switched to a program inhibit setup for the selected memory cell in a subsequent program loop. The C-LATCH CL may temporarily store input data provided from the outside. During the program operation, the target data to be stored in the C-LATCH CL may be stored in the M-LATCH ML and the L-LATCH LL.

The data latches and the cache latches may be referred to as a latch group.

Hereinafter, it is assumed that signals for controlling elements in the page buffer circuit 410 are included in the page buffer control signal PCTL in FIG. 3.

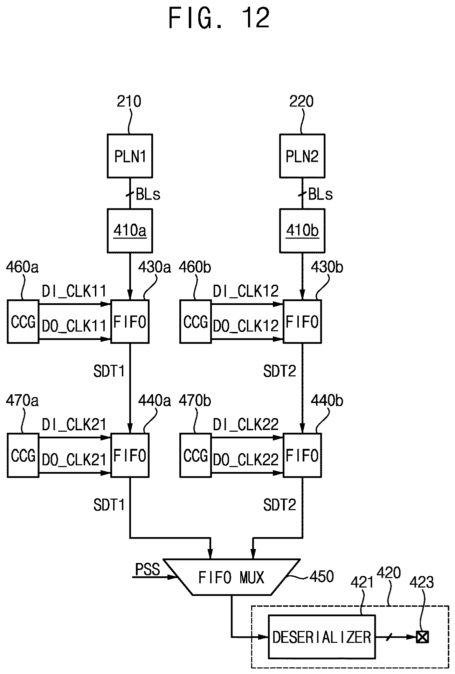

FIG. 12 illustrates a data I/O circuit and components associated with two memory planes in the nonvolatile memory device of FIG. 3.

In FIG. 12, the memory planes 210 and 220, the first page buffer circuit 410a, the second page buffer circuit 410b, FIFO registers 430a, 430b, 440a and 440b, the control clock generators 460a, 460b, 470a and 470b, the multiplexer 450 and the data I/O circuit 420 in the nonvolatile memory device 100 are illustrated.

Referring to FIG. 12, the first memory plane 210 may be connected to the first page buffer circuit 410a through the bit-lines BLs, the first page buffer circuit 410a may be connected to a first FIFO register 430a, the first FIFO register 430a may be connected to a second FIFO register 440a, the second FIFO register 440a may be connected to the multiplexer 450 and the multiplexer 450 may be connected to the data I/O circuit 420.

The second memory plane 220 may be connected to the second page buffer circuit 410b through the bit-lines BLs, the second page buffer circuit 410b may be connected to a third FIFO register 430b, the third FIFO register 430b may be connected to a fourth FIFO register 440b and the four FIFO register 440b may be connected to the multiplexer 450.

The data I/O circuit 420 may include a deserializer 421 and a data I/O pad 423.

In a read operation, the control clock generator 460a (e.g., a first control clock generator 460a) may apply a first input clock signal DI_CLK11 and a first output clock signal DO_CLK11 to the first FIFO register 430a, the control clock generator 470a (e.g., a second control clock generator 470a) may apply a second input clock signal DI_CLK21 and a second output clock signal DO _CLK21 to the second FIFO register 440a and the first data sensed from the first memory plane 210 by the first page buffer circuit 410a may be sequentially stored as the first sub data SDT1 in the first FIFO register 430a and the second FIFO register 440a.

In a read operation, the control clock generator 460b (e.g., a third control clock generator 460b) may apply a first input clock signal DI_CLK12 and a first output clock signal DO_CLK12 to the third FIFO register 430b, the control clock generator 470b (e.g., a fourth control clock generator 470b) may apply a second input clock signal DI_CLK22 and a second output clock signal DO_CLK22 to the fourth FIFO register 440b and the second data sensed from the second memory plane 220 by the second page buffer circuit 410b may be sequentially stored as the second sub data SDT2 in the third FIFO register 430b and the fourth FIFO register 440b.

In an output operation (e.g., in a data output operation), the multiplexer 450 may sequentially select the first sub data SDT1 stored in the second FIFO register 440a and the second sub data SDT2 stored in the fourth FIFO register 440b and may provide the selected sub data to the data I/O circuit 420. The data I/O circuit 420 may deserialize the sub data output from the multiplexer 450 through the deserializer 421 and may output the deserialized data to an outside (e.g., an external circuit) of the nonvolatile memory device 100. The outside may be the memory controller 50.

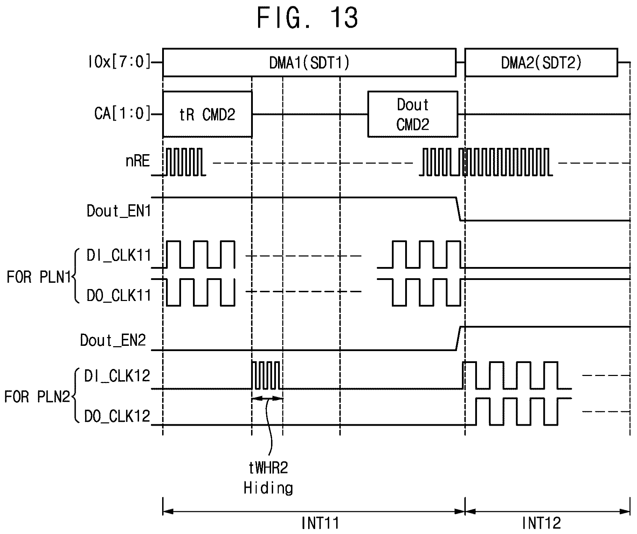

FIG. 13 is a timing diagram illustrating an example operation of the nonvolatile memory device of FIG. 12 according to example implementations.

Referring to FIGS. 12 and 13, during a first time interval INT11, a read enable signal nRE toggles, a first output enable signal Dout_EN1 is activated with a logic high level, the first input clock signal DI_CLK11 and the first output clock signal DO _CLK11 associated with the first memory plane 210 toggle based on a first data output command received before the first time interval INT11 and the first sub data SDT1 is output to a circuit external to the nonvolatile memory device 100 through I/O line IOx[7:0] based on a DMA manner DMA1.

During the first time interval INT11 in which the first sub data SDT1 is output to an external circuit, a second read command tR CMD2 and a second data output command Dout CMD2 associated with the second memory plane 220 are received through command/address line CA[1:0], data stored in the second memory plane 220 is sensed by the second page buffer circuit 410b based on the second read command tR CMD2 and the sensed data is sequentially stored in the third FIFO register 430b and the fourth FIFO register 440b.

During a second time interval INT12, the read enable signal nRE toggles, a second output enable signal Dout_EN2 is activated with a logic high level, the second input clock signal DI_CLK12 and the second output clock signal DO_CLK12 associated with the second memory plane 220 toggle based on the second data output command Dout CMD2 and the second sub data SDT2 is output to a circuit external to the nonvolatile memory device 100 through I/O line IOx[7:0] based on a DMA manner DMA2.

Because the second sub data SDT2 stored in the second memory plane 220 moves the fourth FIFO register 440b via the third FIFO register 430b while the first sub data SDT1 stored in the first memory plane 210 is being output, the second sub data SDT2 may be output immediately in response to (e.g., immediately upon receipt of) the second data output command Dout CMD2 without delay time tWHR2.

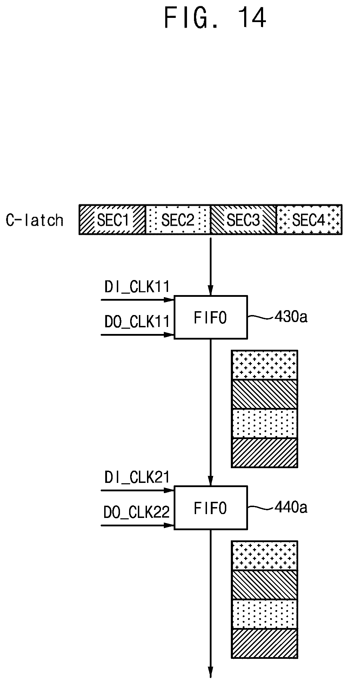

FIG. 14 is a block diagram illustrating an example of the first FIFO register and the second FIFO register in FIG. 12 according to example implementations.

Referring to FIG. 14, page data is divided into four pieces of sector data SEC1, SEC2, SEC3 and SEC4. Each of the four pieces of sector data SEC1, SEC2, SEC3 and SEC4 may be sequentially input to the first FIFO register 430a based on the first input clock signal DI_CLK11 by unit of sector, may be sequentially input to the second FIFO register 440a from the first FIFO register 430a based on the first output clock signal DO_CLK11 and the second input clock signal DI_CLK21 and may be output from the second FIFO register 440a based on the second output clock signal DO _CLK22.

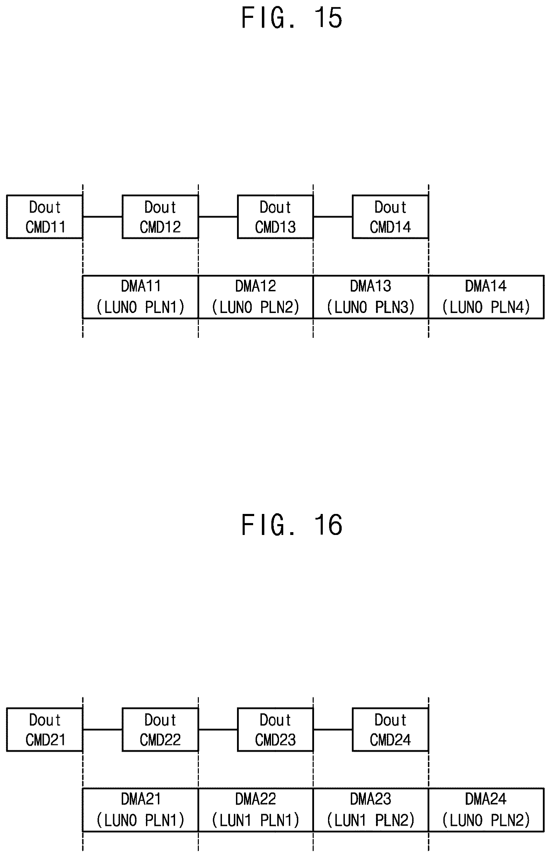

FIG. 15 is a timing diagram illustrating an example operation of the nonvolatile memory device of FIG. 3 according to example implementations.

Referring to FIGS. 3 and 15, when data stored in the first through fourth memory planes 210, 220, 230 and 240 have the same logical unit number (LUN), for example, when the data stored in the first through fourth memory planes 210, 220, 230 and 240 have LUN0, in a read operation, each of the sub data stored in each of the second group of FIFO registers 440a, 440b, 440c and 440d via each of the first group of FIFO registers 430a, 430b, 430c and 430d from each of the first through fourth memory planes 210, 220, 230 and 240 may be output to an external circuit in response to one of data output commands Dout CMD11, Dout CMD12, Dout CMD13 and Dout CMD14, respectively, based on DMA manner DMA11, DMA12, DMA13 and DMA14 without delay time.

FIG. 16 is a timing diagram illustrating an example operation of the nonvolatile memory device of FIG. 3 according to example implementations.

Referring to FIGS. 3 and 16, in which data stored in at least two of the first through fourth memory planes 210, 220, 230 and 240 have different LUNs, for example, when the data stored in the first memory plane 210 have LUN0 and LUN1 and the data stored in the second memory plane 220 have LUN0 and LUN1, in a read operation, each of the sub data stored in each of the second group of FIFO registers 440a and 440b via each of the first group of FIFO registers 430a and 430b from each of the first and second memory planes 210 and 220 may be output to an external circuit in response to one of data output commands Dout CMD21, Dout CMD22, Dout CMD23 and Dout CMD24, respectively, based on DMA manner DMA21, DMA22, DMA23 and DMA24 without delay time.

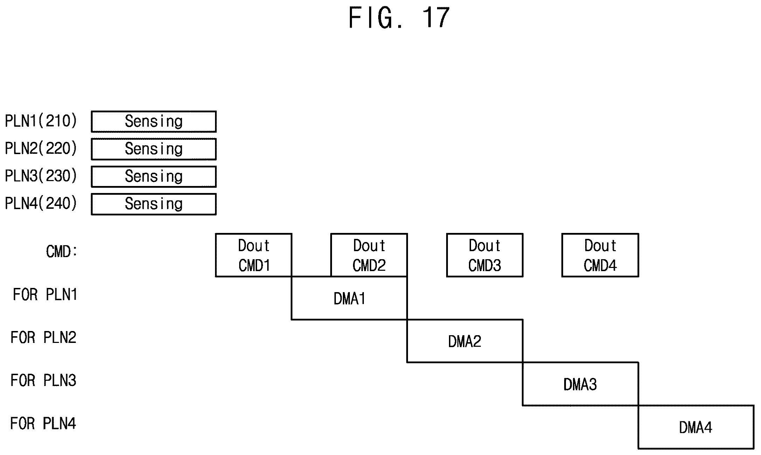

FIG. 17 is a timing diagram illustrating an example operation of the nonvolatile memory device of FIG. 3 according to example implementations.

Referring to FIGS. 3 and 17, data stored in each of the first through fourth memory planes 210, 220, 230 and 240 is sensed simultaneously or in parallel by respective ones of the page buffer circuits 410a, 410b, 410c and 410d and the sensed data is stored in each of the second group of FIFO registers 440a, 440b, 440c and 440d via each of the first group of FIFO registers 430a, 430b, 430c and 430d in response to a read command.

In response to a first data output command Dout CMD1, the data stored in the FIFO register 440a is output to an external circuit through the multiplexer 450 and the data I/O circuit without delay time based on DMA manner DMA1. In response to a second data output command Dout CMD2, the data stored in the FIFO register 440b is output to an external circuit through the multiplexer 450 and the data I/O circuit without delay time based on DMA manner DMA2. In response to a third data output command Dout CMD3, the data stored in the FIFO register 440c is output to an external circuit through the multiplexer 450 and the data I/O circuit without delay time based on DMA manner DMA3. In response to a fourth data output command Dout CMD4, the data stored in the FIFO register 440d is output to an external circuit through the multiplexer 450 and the data I/O circuit without delay time based on DMA manner DMA4.

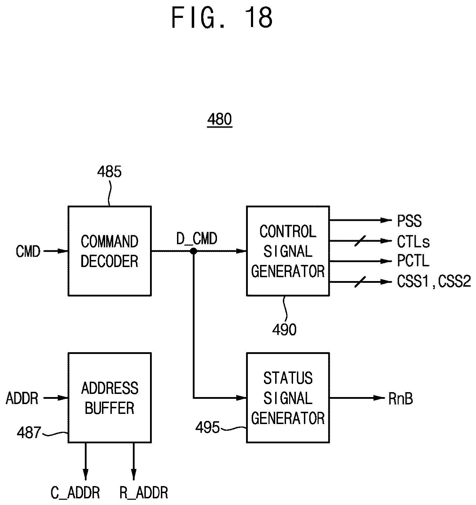

FIG. 18 is a block diagram illustrating an example of the control circuit in the nonvolatile memory device of FIG. 3 according to example implementations.

Referring to FIG. 18, the control circuit 480 may include a command decoder 485, an address buffer 487, a control signal generator 490 and a status signal generator 495.

The command decoder 485 may decode the command CMD and provide a decoded command D_CMD to the control signal generator 490 and the status signal generator 495.

The address buffer 487 may receive the address signal ADDR, provide the row address R_ADDR to the address decoder 300 and provide the column address C_ADDR to the data I/O circuit 420.

The control signal generator 490 may receive the decoded command D_CMD, may generate the control signals CTLs, the plane selection signal PSS, the first clock control signals CCS1 and the second clock control signals CCS2 based on an operation directed by the decoded command D_CMD, may provide the control signals CTLs to the voltage generator 500, may provide the plane selection signal PSS to the multiplexer 450, may provide the first clock control signals CCS1 to the first group of control clock generators 460a, 460b, 460c and 460d and may provide the second clock control signals CCS2 to the second group of control clock generators 470a, 470b, 470c and 470d. The control signal generator 490 may generate the page buffer control signal PCTL based on an operation directed by the decoded command D_CMD, may provide the page buffer control signal PCTL to the page buffer circuits 410a, 410b, 410c and 410d.

The status signal generator 495 may receive the decoded command D_CMD, may monitor an operation directed by the decoded command D_CMD and may transition the status signal RnB to one of a ready state or a busy state based on whether the operation directed by the decoded command D_CMD is completed.

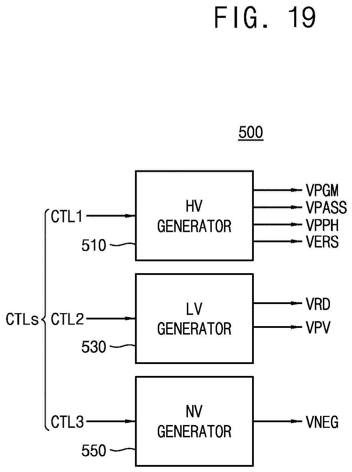

FIG. 19 is a block diagram illustrating an example of the voltage generator in the nonvolatile memory device of FIG. 3 according to example implementations.

Referring to FIG. 19, the voltage generator 500 may include a high voltage HV generator 510 and a low voltage LV generator 530. The voltage generator 500 may further include a negative voltage NV generator 550. The high voltage HV generator 510 may generate voltages that are higher than voltages which the low voltage LV generator 530 generates.

The high voltage generator 510 may be referred to as a first voltage generator, the low voltage generator 530 may be referred to as a second voltage generator and the negative voltage generator 550 may be referred to as a third voltage generator.

The high voltage generator 510 may generate a program voltage VPGM, a pass voltage VPASS, a block selection voltage VPPH, and an erase voltage VERS according to operations directed by the command CMD, in response to a first control signal CTL1.

The program voltage VPGM is applied to the selected word-line, the pass voltage VPASS may be applied to the unselected word-lines, the erase voltage VERS may be applied to a channel of cell strings included in a selected memory block. The block selection voltage VPPH may be applied to each gate of pass transistors coupled to word-lines, a string selection line and a ground selection line. The block selection voltage VPPH may be otherwise known as a first voltage. The first control signal CTL1 may include a plurality of bits which indicate the operations directed by the decoded command D_CMD.

The low voltage generator 530 may generate a program verification voltage VPV and a read voltage VRD according to operations directed by the command CMD, in response to a second control signal CTL2. The second control signal CTL2 may include a plurality of bits which indicate the operations directed by the decode command D_CMD.

The negative voltage generator 550 may generate a negative voltage VNEG which has a negative level according to operations directed by the command CMD, in response to a third control signal CTL3. The third control signal CTL3 may include a plurality of bits which indicate the operations directed by the decoded command D_CMD. The negative voltage VNEG may be applied to a selected word-line and unselected word-lines during a program recovery period and may be applied to the unselected word-lines during a bit-line set-up period.

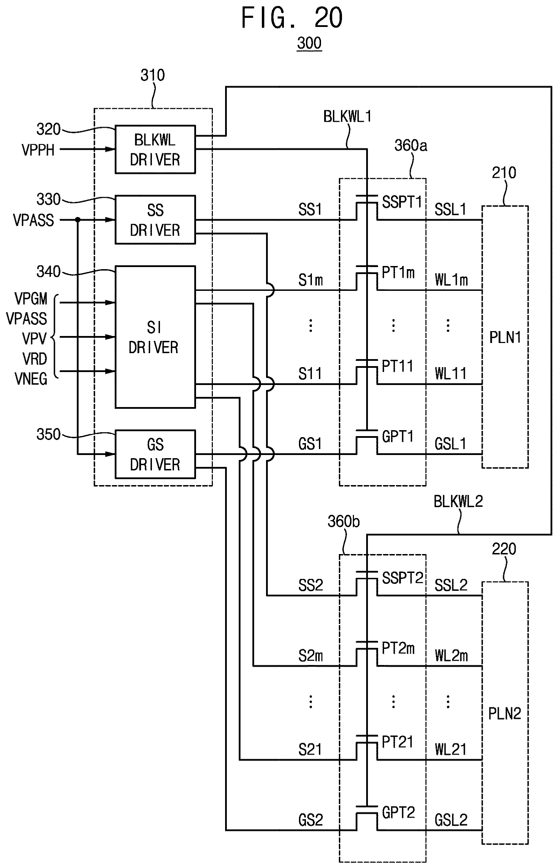

FIG. 20 is a block diagram illustrating an example of the address decoder in the nonvolatile memory device of FIG. 3 according to example implementations.

Referring to FIG. 20, the address decoder 300 may include a driver circuit 310 and pass switch circuits 360a and 360b.

The driver circuit 310 may transfer voltages provided from the voltage generator 500 to the memory cell array 200 in response to a block address. The driver circuit 310 may include a block selection driver BLKWL DRIVER 320, a string selection driver SS DRIVER 330, a driving line driver SI DRIVER 340 and a ground selection driver GS DRIVER 350.

The block selection driver 320 may supply the block selection voltage VPPH from the voltage generator 500 to the pass transistor circuits 360a and 360b in response to the block address. The block selection driver 320 may supply the block selection voltage VPPH to a block word-line BLKWL1 coupled to gates of a plurality of pass transistors GPT1, PT11~PT1m and SSPT1 in the pass transistor circuit 360a and may supply the block selection voltage VPPH to a block word-line BLKWL2 coupled to gates of a plurality of pass transistors GPT2, PT21~PT2m and SSPT2 in the pass transistor circuit 360b. The block selection driver 320 may control the application of various voltages such as a pass voltage, a program voltage, a read voltage to the memory cell array 200.

The pass transistors GPT1, PT11~PT1m and SSPT1 may be coupled to the memory plane 210 through a ground selection line GSL1, a plurality of word-lines WL11~WL1m and a string selection line SSL1 and the pass transistors GPT2, PT21~PT2m and SSPT2 may be coupled to the memory plane 220 through a ground selection line GSL2, a plurality of word-lines WL21~WL2m and a string selection line SSL2.

The string selection driver 330 may supply voltage(s) (for example, pass voltage VPASS) from the voltage generator 500 to the string selection lines SSL1 and SSL2 through the pass transistors SSPT1 and SSPT2 as string selection signals SS1 and SS2. During a program operation, the string selection driver 330 may supply the selection signals SS1 and SS2 so as to turn on all string selection transistors in a selected memory block.

The driving line driver 340 may supply the program voltage VPGM, the pass voltage VPASS, the verification voltage VPV, the read voltage VRD and the negative voltage VNEG from the voltage generator 500 to the word-lines WL11~WL1m through driving lines S11~S1m and the pass transistors PT11~PT1m and may supply the program voltage VPGM, the pass voltage VPASS, the verification voltage VPV, the read voltage VRD and the negative voltage VNEG to the word-lines WL21~WL2m through driving lines S21~S2m and the pass transistors PT21~PT2m.

The ground selection driver 350 may supply voltage(s) (for example, pass voltage VPASS) from the voltage generator 500 to the ground selection lines GSL1 and GSL2 through the pass transistors GPT1 and GPT2 as ground selection signal GS1 and GS2.

The pass transistors GPT1, PT11~PT1m and SSPT1 are configured such that the ground selection line GSL1, the word-lines WL11~WL1m and the string selection line SSL1 are electrically connected to corresponding driving lines, in response to activation of the block selection voltage VPPH on the block word-line BLKWL2. In example implementations, each of the pass transistors GPT1, PT11~PT1m, SSPT1 may include a high voltage transistor capable of enduring high-voltage. The pass transistors GPT2, PT21~PT2m and SSPT2 are configured such that the ground selection line GSL2, the word-lines WL21~WL2m and the string selection line SSL2 are electrically connected to corresponding driving lines, in response to activation of the block selection voltage VPPH on the block word-line BLKWL2. In example implementations, each of the pass transistors GPT2, PT21~PT2m, SSPT2 may include a high voltage transistor capable of enduring high-voltage.

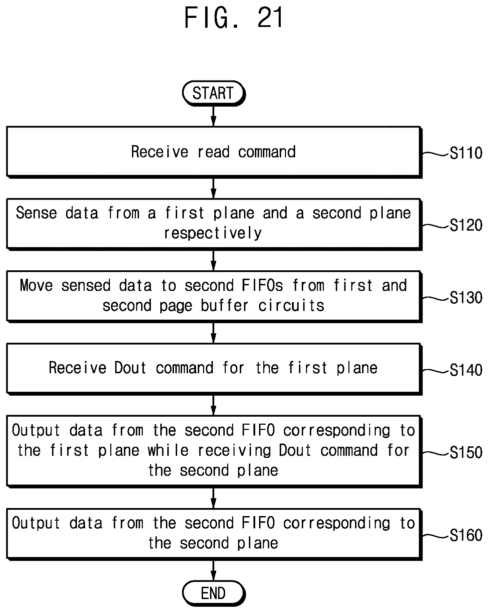

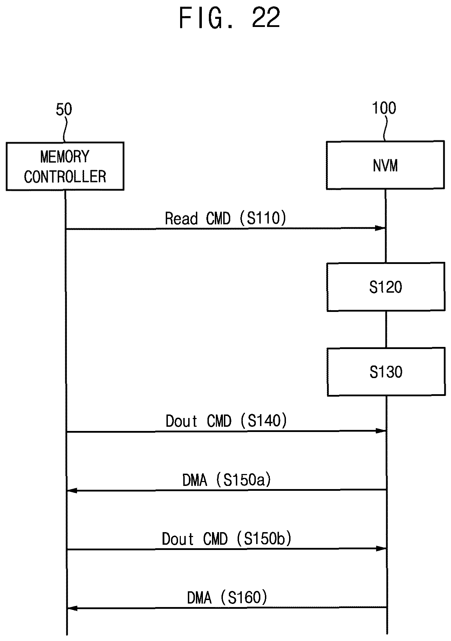

FIG. 21 is a flowchart illustrating an example operation of the nonvolatile memory device and FIG. 22 is a ladder diagram illustrating an example operation of the nonvolatile memory device, according to example implementations.

Referring to FIGS. 1 and 3 through to 22, the nonvolatile memory device 100 may receive a read command from the memory controller 50 (operation S110). Each of the first page buffer circuit 410a and the second page buffer circuit 410b of the nonvolatile memory device 100 may sense data stored in each of the first memory plane 210 and the second memory plane 220 in response to the read command (operation S120) and may move sensed data to a portion of the second group of FIFO registers 440a, 440b, 440c and 440d via a portion of the first group of FIFO registers 430a, 430b, 430c and 430d (operation S130).

The nonvolatile memory device 100 may receive a data output command Dout CMD associated with the first memory plane 210 from the memory controller 50 (operation S140). While the multiplexer 450 and the data I/O circuit 420 of the nonvolatile memory device 100 output the data stored in the first memory plane 210 by a DMA manner (operation S150a), the nonvolatile memory device 100 may receive a data output command Dout CMD associated with the second memory plane 220 from the memory controller 50 (operation S150b). The operations S150a and S150b in FIG. 22 may be included in an operation S150 in FIG. 21.

The multiplexer 450 and the data I/O circuit 420 of the nonvolatile memory device 100 output the data stored in the second memory plane 220 by a DMA manner (operation S160).

Therefore, the nonvolatile memory device 100 may move sensed data from a corresponding memory plane to a corresponding FIFO register among the second group of FIFO registers 440a, 440b, 440c and 440d instead of moving the sensed data to a corresponding page buffer circuit, in response to a read command, and may output the data stored in the corresponding FIFO register as a sub data to a circuit external to the nonvolatile memory device 100 through the multiplexer 450 and the data I/O circuit 420 in response to a data output command. Therefore, the nonvolatile memory device 100 may perform the output operation without delay time tWHR2 corresponding to a delay between a time point at which the nonvolatile memory device 100 receives the data output command and a time point at which the nonvolatile memory device 100 outputs the data. Accordingly, the nonvolatile memory device 100 may perform multi-plane read operation with reduced DMA overhead.

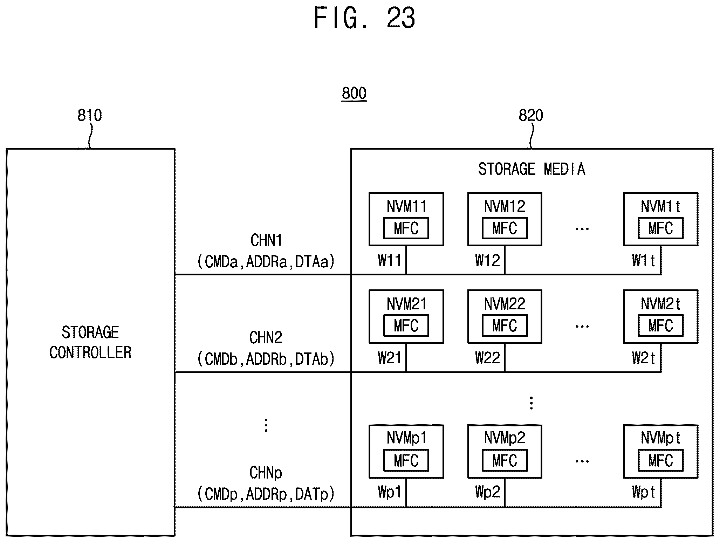

FIG. 23 is a block diagram illustrating a storage device according to example implementations.

Referring to FIG. 23, a storage device 800 may include a storage controller 810 and a storage media 820. The storage device 800 may support a plurality of channels CHN1, CHN2, ..., CHNp (hereinafter CHN1 to CHNp), and the storage media 820 may be connected to the storage controller 810 through the plurality of channels CHN1 to CHNp.

The storage media 820 may include a plurality of nonvolatile memory devices NVM11, NVM12, ..., NVM1t, NVM21, NVM22, ..., NVM2t, NVMp1, NVMp2, ..., NVMpt. For example, each of the nonvolatile memory devices NVM11 to NVMpt may correspond to the nonvolatile memory device 100 of FIG. 3. Each of the nonvolatile memory devices NVM11 to NVMpt may be connected to one of the plurality of media channels CHN1 to CHNp through a way corresponding thereto. For instance, the nonvolatile memory devices NVM11 to NVM1t may be connected to the first medial channel CHN1 through ways W11, W12, ..., W1t, the nonvolatile memory devices NVM21 to NVM2t may be connected to the second media channel CHN2 through ways W21, W22, ..., W2t, and the nonvolatile memory devices NVMp1 to NVMpt may be connected to the p-th media channel CHNp through ways Wp1, Wp2, ..., Wpt. In some example implementations, each of the nonvolatile memory devices NVM1 1 to NVMpt may be implemented as an arbitrary memory unit that may operate according to an individual command from the storage controller 810. For example, each of the nonvolatile memory devices NVM11 to NVMpt may be implemented as a chip or a die, but example implementations are not limited thereto.

Each of the nonvolatile memory devices NVM11 to NVMpt may include a multi-FIFO register circuit MFC. The multi-FIFO register circuit MFC may include the first group of FIFO registers 430a, 430b, 430c and 430d, the second group of FIFO registers 440a, 440b, 440c and 440d, the plurality of first control clock generators 460a, 460b, 460c and 460d, the plurality of second control clock generators 470a, 470b, 470c and 470d and the multiplexer 450.

Therefore, each of the nonvolatile memory devices NVM11 to NVMpt may move sensed data from a corresponding memory plane to a corresponding FIFO register among the second group of FIFO registers instead of moving the sensed data to a corresponding page buffer circuit, in response to a read command, and may output the data stored in the corresponding FIFO register as a sub data to an external circuit through the multiplexer and the data I/O circuit in response to a data output command. Therefore, each of the nonvolatile memory devices NVM11 to NVMpt may perform the output operation without delay time tWHR2 Accordingly, the each of the nonvolatile memory devices NVM11 to NVMpt may perform multi-plane read operation with reduced DMA overhead.

The storage controller 810 may transmit and receive signals to and from the storage media 820 through the plurality of media channels CHN1 to CHNp. For example, the storage controller 810 may correspond to the memory controller 50 in FIG. 2. For example, the storage controller 810 may transmit commands CMDa, CMDb, ..., CMDp, addresses ADDRa, ADDRb, ..., ADDRp and data DTAa, DTAb, ..., DTAp to the storage media 820 through the media channels CHN1 to CHNp or may receive the DTAa to DTAp from the storage media 820.

The storage controller 810 may select one of the nonvolatile memories NVM11 to NVMpt, which is connected to each of the media channels CHN1 to CHNp, by using a corresponding one of the media channels CHN1 to CHNp, and may transmit and receive signals to and from the selected nonvolatile memory device.

The storage controller 810 may transmit and receive signals to and from the storage media 820 in parallel through different media channels.

The storage controller 810 may communicate with an external host according to UFS standards.

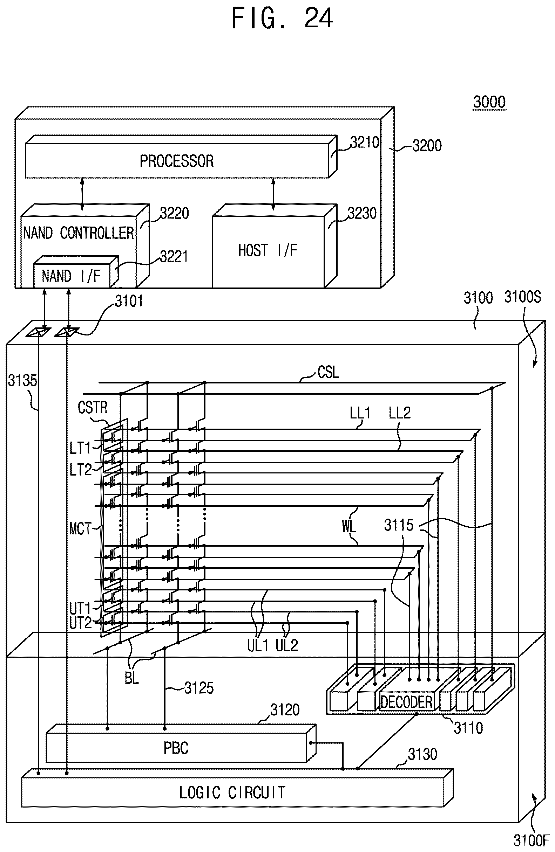

FIG. 24 is a block diagram illustrating an electronic system including a semiconductor device according to some example implementations.

Referring to FIG. 24, an electronic system 3000 may include a semiconductor device 3100 and a controller 3200 electrically connected to the semiconductor device 3100. The electronic system 3000 may be a storage device including one or a plurality of semiconductor devices 3100 or an electronic device including a storage device. For example, the electronic system 3000 may be a solid state drive (SSD) device, a universal serial bus (USB), a computing system, a medical device, or a communication device that may include one or a plurality of semiconductor devices 3100.

The semiconductor device 3100 may be or may include a non-volatile memory device, for example, a nonvolatile memory device that is illustrated with reference to FIGS. 3 to 22. The semiconductor device 3100 may include a first structure 3100F and a second structure 3100S on the first structure 3100F. The first structure 3100F may be a peripheral circuit structure including a decoder circuit 3110, a page buffer circuit (PBC) 3120, and a logic circuit 3130. The second structure 3100S may be a memory cell structure including a bit-line BL, a common source line CSL, word-lines WL, first and second upper gate lines UL1 and UL2, first and second lower gate lines LL1 and LL2, and memory cell strings CSTR between the bit line BL and the common source line CSL.

In the second structure 3100S, each of the memory cell strings CSTR may include lower transistors LT1 and LT2 adjacent to the common source line CSL, upper transistors UT1 and UT2 adjacent to the bit-line BL, and a plurality of memory cell transistors MCT between the lower transistors LT1 and LT2 and the upper transistors UT1 and UT2. The number of the lower transistors LT1 and LT2 and the number of the upper transistors UT1 and UT2 may be varied in accordance with example implementations.

In some example implementations, the upper transistors UT1 and UT2 may include string selection transistors, and the lower transistors LT1 and LT2 may include ground selection transistors. The lower gate lines LL1 and LL2 may be gate electrodes of the lower transistors LT1 and LT2, respectively. The word lines WL may be gate electrodes of the memory cell transistors MCT, respectively, and the upper gate lines UL1 and UL2 may be gate electrodes of the upper transistors UT1 and UT2, respectively.

In some example implementations, the lower transistors LT1 and LT2 may include a lower erase control transistor LT1 and a ground selection transistor LT2 that may be connected with each other in series. The upper transistors UT1 and UT2 may include a string selection transistor UT1 and an upper erase control transistor UT2. At least one of the lower erase control transistor LT1 and the upper erase control transistor UT2 may be used in an erase operation for erasing data stored in the memory cell transistors MCT through gate induced drain leakage (GIDL) phenomenon.

The common source line CSL, the first and second lower gate lines LL1 and LL2, the word lines WL, and the first and second upper gate lines UL1 and UL2 may be electrically connected to the decoder circuit 3110 through first connection wirings 3115 extending to the second structure 3110S from the first structure 3100F. The bit-lines BL may be electrically connected to the page buffer circuit 3120 through second connection wirings 3125 extending to the second structure 3100S from the first structure 3100F.

In the first structure 3100F, the decoder circuit 3110 and the page buffer circuit 3120 may perform a control operation for at least one selected memory cell transistor among the plurality of memory cell transistors MCT. The decoder circuit 3110 and the page buffer circuit 3120 may be controlled by the logic circuit 3130. The semiconductor device 3100 may communicate with the controller 3200 through an input/output pad 3101 electrically connected to the logic circuit 3130. The input/output pad 3101 may be electrically connected to the logic circuit 3130 through an input/output connection wiring 3135 extending to the second structure 3100S from the first structure 3100F.

The controller 3200 may include a processor 3210, a NAND controller 3220, and a host interface (I/F) 3230. The electronic system 3000 may include a plurality of semiconductor devices 3100, and in this case, the controller 3200 may control the plurality of semiconductor devices 3100.

The processor 3210 may control operations of the electronic system 3000 including the controller 3200. The processor 3210 may be operated by firmware, and may control the NAND controller 3220 to access the semiconductor device 3100. The NAND controller 3220 may include a NAND interface 3221 for communicating with the semiconductor device 3100. Through the NAND interface 3221, control command for controlling the semiconductor device 3100, data to be written in the memory cell transistors MCT of the semiconductor device 3100, data to be read from the memory cell transistors MCT of the semiconductor device 3100, etc., may be transferred. The host interface 3230 may provide communication between the electronic system 3000 and an external circuit host. When control command is received from the outside host through the host interface 3230, the processor 3210 may control the semiconductor device 3100 in response to the control command.

A nonvolatile memory device or a storage device according to example implementations may be packaged using various package types or package configurations.

Embodiments are set out in the following Clauses:
Clause 1. A nonvolatile memory device comprising:
   a plurality of page buffer circuits corresponding to a plurality of memory planes, each of the plurality of page buffer circuits connected to a respective one of the plurality of memory planes through corresponding bit-lines;
   a first group of first-in/first-out (FIFO) registers connected to the plurality of page buffer circuits, respectively;
   a second group of FIFO registers connected to the first group of FIFO registers, respectively;
   a multiplexer configured to select one of a plurality of sub data output from the second group of FIFO registers, in response to a plane selection signal; and
   a control circuit configured to control the plurality of page buffer circuits, the first group of FIFO registers, and the second group of FIFO registers,
   wherein the control circuit is configured to:
      perform a first read operation, in response to a first read command, wherein the first read operation comprises sensing a first data stored in a first memory plane among the plurality of memory planes through a first page buffer circuit and storing the first sensed data in a corresponding first set of FIFO registers among the first group of FIFO registers and the second group of FIFO registers as a first sub data; and
      perform a second read operation, in response to a second read command, wherein the second read operation comprises sensing a second data stored in a second memory plane among the plurality of memory planes through a second page buffer circuit and storing the second sensed data in a corresponding second set of FIFO registers among the first group of FIFO registers and the second group of FIFO registers as a second sub data while performing a first output operation to output the first sub data to a circuit outside of the nonvolatile memory device through the multiplexer and a data input/output circuit in response to a first data output command.
Clause 2. The nonvolatile memory device of Clause 1,
   wherein the first group of FIFO registers are disposed adjacent to the plurality of page buffer circuits, and
   wherein the second group of FIFO registers are disposed adjacent to the multiplexer.
Clause 3. The nonvolatile memory device of Clause 1 or Clause 2, wherein the control circuit is configured to perform the first output operation immediately upon receipt of the first data output command.
Clause 4. The nonvolatile memory device of any preceding Clause, wherein the control circuit is configured to: perform a third read operation, in response to a third read command, wherein the first read operation comprises sensing a third data stored a third memory plane among the plurality of memory planes through a third page buffer circuit and storing the second sensed data in a corresponding third set of FIFO registers among the first group of FIFO registers and the second group of FIFO registers as a third sub data while performing a second output operation to output the second sub data to the circuit outside of the nonvolatile memory device through the multiplexer and the data input/output circuit in response to a second data output command.
Clause 5. The nonvolatile memory device of Clause 4, wherein the first data stored in the first memory plane and the second data stored in the second memory plane have a same logical unit number.
Clause 6. The nonvolatile memory device of Clause 5, wherein the control circuit is configured to perform the second output operation immediately upon receipt of the second data output command.
Clause 7. The nonvolatile memory device of any of Clauses 4, wherein the first data stored in the first memory plane and the second data stored in the second memory plane have different logical unit numbers.
Clause 8. The nonvolatile memory device of any preceding Clause, comprising:
   a plurality of first control clock generators corresponding to the first group of FIFO registers; and
   a plurality of second control clock generators corresponding to the second group of FIFO registers,
   wherein the corresponding first set of FIFO registers include a first FIFO register connected to the first page buffer circuit and a second FIFO register connected to the first FIFO register.
Clause 9. The nonvolatile memory device of Clause 8, wherein the control circuit is configured to perform the first read operation by controlling a first control clock generator among the plurality of first control clock generators and by controlling a second control clock generator among the plurality of second control clock generators.
Clause 10. The nonvolatile memory device of Clause 9,
   wherein the first control clock generator is configured to output a first input clock signal and a first output clock signal to the first FIFO register; and
   wherein the first FIFO register is configured to store the first sensed data output from the first page buffer circuit, based on the first input clock signal, and configured to output the first sensed data to the second FIFO register, based on the first output clock signal.
Clause 11. The nonvolatile memory device of Clause 10,
   wherein the second control clock generator is configured to output a second input clock signal and a second output clock signal to the second FIFO register; and
   wherein the second FIFO register is configured to store the second sensed data output from the first FIFO register, based on the second input clock signal, and configured to output the second sensed data to the multiplexer as the first sub data, based on the second output clock signal.
Clause 12. The nonvolatile memory device of any of Clauses 8-11, wherein the control circuit is configured to perform the second read operation by controlling a third control clock generator among the plurality of first control clock generators and by controlling a fourth control clock generator among the plurality of second control clock generators.
Clause 13. The nonvolatile memory device of any of Clauses 8-12, wherein the control circuit is configured to, in response to a corresponding read command, control the plurality of page buffer circuits, the plurality of first control clock generators, and the plurality of second control clock generators to cause corresponding data to be sequentially stored in the second group of FIFO registers via the first group of FIFO registers.
Clause 14. The nonvolatile memory device of Clause 13, wherein the control circuit is configured to, in response to corresponding data output commands, control an output operation such that data stored in the second group of FIFO registers are output immediately.
Clause 15. The nonvolatile memory device of Clause 14, wherein data stored in the plurality of memory planes have a same logical unit number.
Clause 16. The nonvolatile memory device of Clause 14, wherein data stored in at least two of the plurality of memory planes have different logical unit numbers.
Clause 17. The nonvolatile memory device of any preceding Clause, wherein:
   the plurality of memory planes are disposed in a first semiconductor layer,
   the plurality of page buffer circuits, the first group of FIFO registers, the second group of FIFO registers, and the multiplexer are disposed in a second semiconductor layer, and
   the second semiconductor layer is stacked in a vertical direction with respect to the first semiconductor layer.
Clause 18. A memory system comprising:
   a nonvolatile memory device configured to output a read data; and
   a memory controller configured to control the nonvolatile memory device and correct errors in the read data,
   wherein the nonvolatile memory device comprises:
      a plurality of page buffer circuits corresponding to a plurality of memory planes, each of the plurality of page buffer circuits connected to a respective one of the plurality of memory planes through corresponding bit-lines;
      a first group of first-in/first-out (FIFO) registers connected to the plurality of page buffer circuits, respectively;
      a second group of FIFO registers connected to the first group of FIFO registers, respectively;
      a multiplexer configured to select one of a plurality of sub data output from the second group of FIFO registers, in response to a plane selection signal; and
      a control circuit configured to control the plurality of page buffer circuits, the first group of FIFO registers and the second group of FIFO registers,
      wherein the control circuit is configured to:
         perform a first read operation, in response to a first read command, wherein the first read operation comprises sensing a first data stored in a first memory plane among the plurality of memory planes through a first page buffer circuit and storing the first sensed data in a corresponding first set of FIFO registers among the first group of FIFO registers and the second group of FIFO registers as a first sub data; and
         perform a second read operation, in response to a second read command, wherein the second read operation comprises sensing a second data stored in a second memory plane among the plurality of memory planes through a second page buffer circuit and storing the second sensed data in a corresponding second set of FIFO registers among the first group of FIFO registers and the second group of FIFO registers as a second sub data while performing a first output operation to output the first sub data to the memory controller through the multiplexer and a data input/output circuit in response to a first data output command.
Clause 19. The memory system of Clause 18, wherein the memory controller includes:
   an error correction code (ECC) engine configured to correct errors in the read data by performing an ECC decoding on the read data; and
   a processor configured to control the ECC engine.
Clause 20. A nonvolatile memory device comprising:
   a memory cell array including a plurality of memory planes;
   a plurality of page buffer circuits corresponding to a plurality of memory planes, each of the plurality of page buffer circuits connected to a respective one of the plurality of memory planes through corresponding bit-lines;
   a first group of first-in/first-out (FIFO) registers connected to the plurality of page buffer circuits, respectively;
   a second group of FIFO registers connected to the first group of FIFO registers, respectively;
   a multiplexer configured to select one of a plurality of sub data output from the second group of FIFO registers, in response to a plane selection signal; and
   a control circuit configured to control the plurality of page buffer circuits, the first group of FIFO registers and the second group of FIFO registers,
   wherein the control circuit is configured to:
      perform a first read operation, in response to a first read command, wherein the first read operation comprises sensing a first data stored in a first memory plane among the plurality of memory planes through a first page buffer circuit and storing the first sensed data in a first FIFO register among the first group of FIFO registers and in a second FIFO register among the second group of FIFO registers as a first sub data; and
      perform a second read operation, in response to a second read command, wherein the second read operation comprises sensing a second data stored in a second memory plane among the plurality of memory planes through a second page buffer circuit and storing the second sensed data in a third FIFO register among the first group of FIFO registers and in a fourth FIFO register among the second group of FIFO registers as a second sub data while performing a first output operation to output the first sub data to a circuit outside of the nonvolatile memory device through the multiplexer and a data input/output circuit in response to a first data output command,
      wherein the control circuit is configured to perform the first output operation immediately upon receipt of the first data output command.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

The foregoing is illustrative of example implementations and is not to be construed as limiting thereof. Although a few example implementations have been described, those skilled in the art will readily appreciate that many modifications are possible in the example implementations without materially departing from the novel teachings and advantages of the present disclosure. Accordingly, all such modifications are intended to be included within the scope of the present disclosure as defined in the claims.

## Claims

1. A nonvolatile memory device comprising:
a plurality of page buffer circuits (410a, 410b, 410c, 410d) corresponding to a plurality of memory planes (210, 220, 230, 240), each of the plurality of page buffer circuits (410a, 410b, 410c, 410d) being connected to a respective one of the plurality of memory planes (210, 220, 230, 240) through corresponding bit-lines;
a first group of first-in/first-out, FIFO, registers (430a, 430b, 430c, 430d) connected to the plurality of page buffer circuits (410a, 410b, 410c, 410d), respectively;
a second group of FIFO registers (440a, 440b, 440c, 440d) connected to the first group of FIFO registers (430a, 430b, 430c, 430d), respectively;
a multiplexer (450) configured to select one of a plurality of sub data output from the second group of FIFO registers (440a, 440b, 440c, 440d), in response to a plane selection signal; and
a control circuit (480) configured to control the plurality of page buffer circuits (210, 220, 230, 240), the first group of FIFO registers (430a, 430b, 430c, 430d), and the second group of FIFO registers (440a, 440b, 440c, 440d),
wherein the control circuit (480) is configured to:
perform a first read operation, in response to a first read command, wherein the first read operation comprises sensing a first data stored in a first memory plane (210) among the plurality of memory planes (210, 220, 230, 240) through a first page buffer circuit (410a) and storing the first sensed data in a corresponding first set of FIFO registers among the first group of FIFO registers (430a, 430b, 430c, 430d) and the second group of FIFO registers (440a, 440b, 440c, 440d) as a first sub data; and
perform a second read operation, in response to a second read command, wherein the second read operation comprises sensing a second data stored in a second memory plane (220) among the plurality of memory planes through a second page buffer circuit (410b) and storing the second sensed data in a corresponding second set of FIFO registers among the first group of FIFO registers (430a, 430b, 430c, 430d) and the second group of FIFO registers (440a, 440b, 440c, 440d) as a second sub data while performing a first output operation to output the first sub data to a circuit outside of the nonvolatile memory device through the multiplexer (450) and a data input/output circuit (420) in response to a first data output command.

2. The nonvolatile memory device of claim 1,
wherein the first group of FIFO registers (430a, 430b, 430c, 430d) are disposed adjacent to the plurality of page buffer circuits (410a, 410b, 410c, 410d),
wherein the second group of FIFO registers (440a, 440b, 440c, 440d) are disposed adjacent to the multiplexer (450), and
wherein the control circuit (480) is configured to perform the first output operation immediately upon receipt of the first data output command.

3. The nonvolatile memory device of claim 1 or claim 2, wherein the control circuit (480) is configured to:
perform a third read operation, in response to a third read command, wherein the third read operation comprises sensing a third data stored in a third memory plane (230) among the plurality of memory planes (210, 220, 230, 240) through a third page buffer circuit (410c) and storing the third sensed data in a corresponding third set of FIFO registers among the first group of FIFO registers (430a, 430b, 430c, 430d) and the second group of FIFO registers (440a, 440b, 440c, 440d) as a third sub data while performing a second output operation to output the second sub data to the circuit outside of the nonvolatile memory device through the multiplexer (450) and the data input/output circuit (420) in response to a second data output command.

4. The nonvolatile memory device of claim 3, wherein the first data stored in the first memory plane (210) and the second data stored in the second memory plane (220) have a same logical unit number, and wherein the control circuit (480) is configured to perform the second output operation immediately upon receipt of the second data output command.

5. The nonvolatile memory device of claim 3, wherein the first data stored in the first memory plane (210) and the second data stored in the second memory plane (220) have different logical unit numbers.

6. The nonvolatile memory device of any preceding claim, further comprising:
a first group of control clock generators (460a, 460b, 460c, 460d) corresponding to the first group of FIFO registers (430a, 430b, 430c, 430d); and
a second group of control clock generators (470a, 470b, 470c, 470d) corresponding to the second group of FIFO registers (440a, 440b, 440c, 440d),
wherein the corresponding first set of FIFO registers include a first FIFO register (430a) connected to the first page buffer circuit (410a) and a second FIFO register (440a) connected to the first FIFO register (430a).

7. The nonvolatile memory device of claim 6, wherein the control circuit (480) is configured to perform the first read operation by controlling a first control clock generator (460a) among the first group of control clock generators (460a, 460b, 460c, 460d) and by controlling a second control clock (470a) generator among the second group of control clock generators (470a, 470b, 470c, 470d).

8. The nonvolatile memory device of claim 7,
wherein the first control clock generator (460a) is configured to output a first input clock signal and a first output clock signal to the first FIFO register (430a); and
wherein the first FIFO register (430a) is configured to store the first sensed data output from the first page buffer circuit (410a), based on the first input clock signal, and configured to output the first sensed data to the second FIFO register (440a), based on the first output clock signal.

9. The nonvolatile memory device of claim 7 or claim 8,
wherein the second control clock generator (470a) is configured to output a second input clock signal and a second output clock signal to the second FIFO register (440a); and
wherein the second FIFO register (440a) is configured to store the second sensed data output from the first FIFO register (430a), based on the second input clock signal, and configured to output the second sensed data to the multiplexer (450) as the first sub data, based on the second output clock signal.

10. The nonvolatile memory device of any of claims 6-9, wherein the control circuit (480) is configured to perform the second read operation by controlling a third control clock generator (460c) among the first group of control clock generators (460a, 460b, 460c, 460d) and by controlling a fourth control clock generator (470a) among the second group of control clock generators (470a, 470b, 470c, 470d).

11. The nonvolatile memory device of any of claims 6-10, wherein the control circuit (480) is configured to, in response to a corresponding read command, control the plurality of page buffer circuits (410a, 410b, 410c, 410d), the first group of control clock generators (460a, 460b, 460c, 460d), and the second group of control clock generators (470a, 470b, 470c, 470d) to cause corresponding data to be sequentially stored in the second group of FIFO registers (440a, 440b, 440c, 440d) via the first group of FIFO registers (430a, 430b, 430c, 430d), and
wherein the control circuit (480) is configured to, in response to corresponding data output commands, control an output operation such that data stored in the second group of FIFO registers (440a, 440b, 440c, 440d) are output immediately.

12. The nonvolatile memory device of claim 11, wherein data stored in the plurality of memory planes (210, 220, 230, 240) have a same logical unit number.

13. The nonvolatile memory device of claim 11, wherein data stored in at least two of the plurality of memory planes (210, 220, 230, 240) have different logical unit numbers.

14. The nonvolatile memory device of any preceding claim, wherein:
the plurality of memory planes (210, 220, 230, 240) are disposed in a first semiconductor layer (L1),
the plurality of page buffer circuits (410a, 410b, 410c, 410d), the first group of FIFO registers (430a, 430b, 430c, 430d), the second group of FIFO registers (440a, 440b, 440c, 440d), and the multiplexer (450) are disposed in a second semiconductor layer (L2), and
the second semiconductor layer (L2) is stacked in a vertical direction with respect to the first semiconductor layer (L1).

15. A memory system comprising:
a nonvolatile memory device (100) according to any preceding claim, wherein the nonvolatile memory device (100) is configured to output a read data; and
a memory controller (50) configured to control the nonvolatile memory device (100) and correct errors in the read data.
